# EUROPEAN PATENT APPLICATION

(11) **EP 4 685 621 A1**
(43) Date of publication of application: **28.01.2026**
(21) Application number: 25183188.9
(22) Date of filing: 17.06.2025
(51) Int. Cl.: G06F 3/041, G06F 1/16, G06F 3/044, G06F 3/046

(54) **DISPLAY DEVICE AND ELECTRONIC DEVICE INCLUDING THE SAME**

(30) Priority: 24.07.2024 KR 20240098141; 31.07.2024 KR 20240101804
(71) Applicant: Samsung Display Co., Ltd, Yongin-si, Gyeonggi-do (KR)
(72) Inventor: Shin, Jaiku, 17113 Giheung-gu, Yongin-si, Gyeonggi-Do (KR); La, Sojeong, 17113 Giheung-Gu, Yongin-si, Gyeonggi-Do (KR); Park, Sungjune, 17113 Giheung-Gu, Yongin-si, Gyeonggi-Do (KR)
(74) Representative: Dr. Weitzel & Partner

(57) **Abstract**

A display device includes a display panel including a folding area. An input sensor is disposed on the display panel. The input sensor senses a first input by a touch of a user and a second input by a pen or stylus. A base film is disposed under the display panel. An electromagnetic shield layer is disposed under the base film. A support plate is disposed under the electromagnetic shield layer. Openings overlapping the folding area are defined in the support plate. An adhesive layer is disposed between the electromagnetic shield layer and the support plate.

## Description

The present invention relates to a display device and an electronic device including the same.

Electronic devices, such as smart phones, digital cameras, laptop computers, navigation systems, and smart televisions commonly include display devices to present images to users. These display devices generate and deliver images via their screens.

Recently, advancements in display technology have led to the development of various types of display devices, including flexible display devices that can bend into curved shapes, fold, or even roll. These flexible displays offer enhanced portability and improved user convenience due to their adaptable shapes. Among these, folding display devices are designed to fold and unfold along specific folding axes, enabling compactness and versatility.

A typical display device may include a display panel that displays an image, an input sensor that is disposed on the display panel and senses an input through a touch of a user, and a digitizer that is disposed under the display panel and senses an input through a stylus or pen device. The digitizer is generally separately disposed under the display panel, and a separate shield layer is then used to shield electromagnetic waves that affect an operation of the digitizer. This structure may result in a thickened display panel.

The invention is defined by the features of the independent claims. Preferred embodiments are provided in the dependent claims and the description.

According to an embodiment of the invention, a display device includes a display panel including a folding area. An input sensor is disposed on the display panel. The input sensor senses a first input by a touch of a user and a second input by a pen or stylus. A base film is disposed under the display panel. An electromagnetic shield layer is disposed under the base film. A support plate is disposed under the electromagnetic shield layer. Openings of the base plate overlap the folding area. An adhesive layer is disposed between the electromagnetic shield layer and the support plate.

According to an alternative embodiment of the invention, a display device includes a display panel including a folding area. An input sensor is disposed on the display panel. The input sensor senses a first input by a touch of a user and a second input by a pen or stylus. An electromagnetic shield layer is disposed under the display panel. A support plate is disposed under the electromagnetic shield layer. Openings of the support plate overlap the folding area. The support plate includes a first metal layer, and a second metal layer disposed on the first metal layer. An electrical conductivity of the second metal layer is different from that of the first metal layer.

A preferred embodiment of the invention is an electronic device which includes a display device as described herein, in which a first hole area, through which an optical signal passes, is defined. An electronic optical module is disposed under the display device, overlapping the first hole area. The electronic optical module receives the optical signal. A case accommodates the display device and the electronic optical module. The display device includes a display panel including a folding area, an input sensor disposed on the display panel, and that senses a first input by a touch of a user and a second input by a pen or styles. The display device may include a base film disposed under the display panel, an electromagnetic shield layer disposed under the base film, a support plate disposed under the electromagnetic shield layer, and in which openings overlapping the folding area are defined, and an adhesive layer disposed between the electromagnetic shield layer and the support plate. The support plate may include a first metal layer, and a second metal layer disposed on the first metal layer. The second metal layer has an electrical conductivity that is different from that of the first metal layer.

The above and other objects and features of the present invention will become apparent by describing in detail embodiments thereof with reference to the accompanying drawings.
FIG. 1 is a perspective view of an electronic device according to an embodiment of the present invention.
FIG. 2 is a perspective view illustrating a folding state of the electronic device illustrated in FIG. 1.
FIG. 3 is an exploded perspective view of the electronic device illustrated in FIG. 1.
FIG. 4 is a block diagram of the electronic device illustrated in FIG. 3.
FIG. 5 is a cross-sectional view illustrating an electronic panel including a display panel illustrated in FIG. 3 by way of example.
FIG. 6 is a cross-sectional view illustrating a display panel illustrated in FIG. 5 by way of example.
FIG. 7 is a plan view of a display panel illustrated in FIG. 3.
FIG. 8 is a cross-sectional view illustrating an electronic panel corresponding to any one pixel illustrated in FIG. 7 by way of example.
FIG. 9 is a plan view of an input sensor illustrated in FIG. 5.
FIG. 10 is an enlarged plan view of a first area A1 illustrated in FIG. 9.
FIG. 11 is a plan view illustrating a detailed configuration of a first pen sensing electrode and the (1-2)-th sensing electrode illustrated in FIG. 10.
FIG. 12A is a cross-sectional view, taken along line X-X' illustrated in FIG. 10.
FIG. 12B is a cross-sectional view taken along line Y-Y' illustrated in FIG. 10.
FIGS. 13A, 13B, and 13C are plan views illustrating driving of pen sensing electrodes illustrated in FIG. 9.
FIG. 14 is a plan view illustrating a charging operation of a pen/stylus that is disposed on an input sensor.
FIG. 15 is a plan view illustrating a sensing operation for a touch of a pen illustrated in FIG. 14.
FIG. 16 is a cross-sectional view taken along line I-I' illustrated in FIG. 7.
FIG. 17 is a cross-sectional view illustrating a configuration of a comparative display device according to a comparative embodiment.
FIG. 18A is a cross-sectional view taken along line II-II' illustrated in FIG. 7.
FIG. 18B is a cross-sectional view illustrating a state, in which a bending area illustrated in FIG. 18A is bent.
FIG. 19 is a perspective view of a support plate illustrated in FIG. 16.
FIG. 20 is an enlarged plan view of a second area A2 illustrated in FIG. 11.
FIG. 21 is a plan view illustrating a configuration of a support plate according to an embodiment of the present invention.
FIG. 22 is a cross-sectional view illustrating a folding state of a display device illustrated in FIG. 16.
FIGS. 23 to 33 are cross-sectional views illustrating configurations of display devices according to various embodiments of the present invention.

In the specification, when it is mentioned that a component (or an area, a layer, a part, or the like) is "disposed on", "connected to", or "coupled to" another component, it may mean that the former component may be directly disposed on, connected to, or coupled to the latter component or a third component may be disposed between the components.

The same reference numerals may denote the same components throughout the specification and the drawings. Furthermore, while each drawing may represent one or more particular embodiments of the present invention, drawn to scale, such that the relative lengths, thicknesses, and angles can be inferred therefrom, it is to be understood that the present invention is not necessarily limited to the relative lengths, thicknesses, and angles shown. Changes to these values may be made within the scope of the present invention, for example, to allow for manufacturing limitations and the like.

The term "and/or" includes one or more combinations that may be defined by the associated components.

Furthermore, in describing the various components, the terms, such as first and second may be used, but the present invention is not necessarily limited by the terms. The terms are used for distinguishing the components. For example, a first component may be named a second component, and similarly the second component also may be named the first component while not departing from the scope of the present invention. A singular expression includes a plural expression unless an exemption is explicitly described in the context.

Furthermore, the terms, such as "under", "below", "on", and "above", are used to describe an associative relationship between the components illustrated in the drawings. The terms are relative concepts, and are described with respect to directions indicated in the drawings.

When the terms, such as "comprise" and/or "comprising", is used in the specification, it should be understood that they specify presence of the above-mentioned features, numbers, steps, operations, components, parts, and/or combinations thereof, and do not exclude presence or addition of one or more other numbers, steps, operations, components, parts, and/or combinations thereof.

Embodiments of the present invention relate to a display devices, such as one that is flexible or foldable, in which the thickness of the display panel may be reduced while maintaining or improving functionality. This may be accomplished using a specialized input sensor that is integrated to handle both a traditional touch, such as that of a user's finger or the like, and pen/stylus input efficiently within a reduced structure, removing the need for separate components like digitizers.

Additionally, special electromagnetic shielding may be used to protect the functionality of the input sensor without adding unnecessary bulk. The folding mechanism design may include a folding area with specified layers and structures (e.g., support plates with openings) to ensure flexibility without compromising durability.

The device may additionally feature a layered architecture including the display panel, base film, electromagnetic shield layer, and other components to create a thinner, more efficient system.

Accordingly, devices like foldable smartphones and tablets may be improved by combining compactness, durability, and advanced input functionality.

Hereinafter, embodiments of the present invention will be described with reference to the drawings.

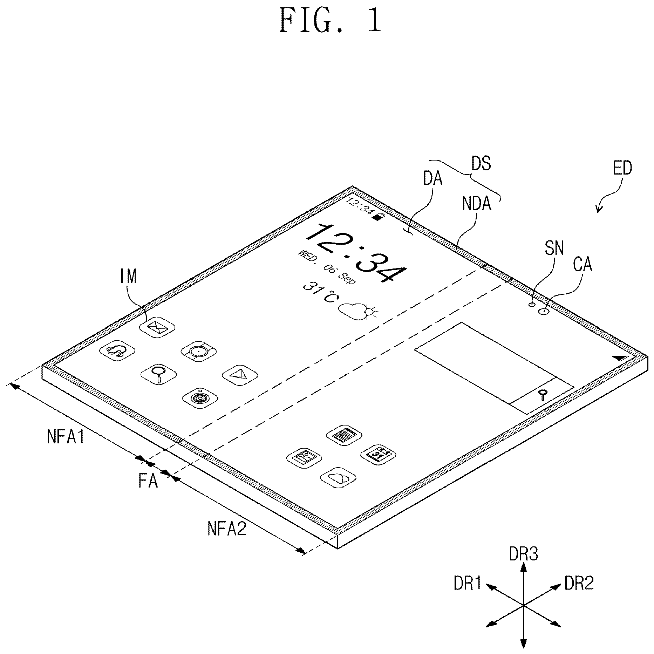

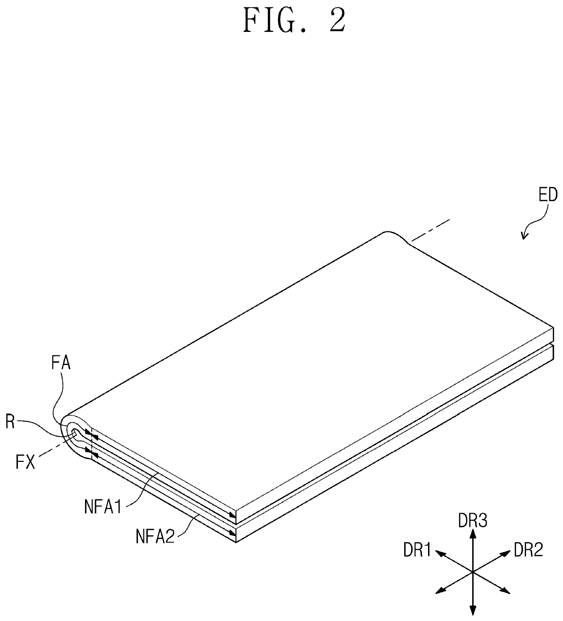

FIG. 1 is a perspective view of an electronic device according to an embodiment of the present invention. FIG. 2 is a perspective view illustrating a folding state of the electronic device illustrated in FIG. 1.

Referring to FIG. 1, an electronic device ED, according to an embodiment of the present invention, may have a plane that is defined by a first direction DR1, and a second direction DR2 that crosses the first direction DR1. When viewed in a plan view, the electronic device ED may have a substantially rectangular shape. However, the present invention is not necessarily limited thereto, and the electronic device ED may have various shapes, such as a circle, or another rounded shape, or any polygon. The electronic device ED may be a flexible electronic device.

Hereinafter, a direction that is substantially perpendicular to the plane defined by the first direction DR1 and the second direction DR2 is defined as a third direction DR3. Furthermore, in the specification, "when viewed on a plane" or "in a plan view" may be defined as a state, in which it is viewed from the third direction DR3.

The electronic device ED may include a folding area FA and a plurality of non-folding areas NFA1 and NFA2. The non-folding areas NFA1 and NFA2 may include a first non-folding area NFA1 and a second non-folding area NFA2. The folding area FA may be disposed between the first non-folding area NFA1 and the second non-folding area NFA2. The first non-folding area NFA1, the folding area FA, and the second non-folding area NFA2 may be arranged in the first direction DR1.

By way of example, one folding area FA and two non-folding areas NFA1 and NFA2 are illustrated, but the number of the folding areas FA and non-folding areas NFA1 and NFA2 is not necessarily limited thereto. For example, the electronic device ED may include more than two non-folding areas, and a plurality of folding areas disposed between the non-folding areas.

An upper surface of the electronic device ED may be defined as a display surface DS, and the display surface DS may have the plane defined by the first direction DR1 and the second direction DR2. Images IM that are generated by the electronic device ED may be provided to a user through the display surface DS.

The display surface DS may include a display area DA and a non-display area NDA proximate to the display area DA. The display area DA may display an image, and the non-display area NDA might not display an image. The non-display area NDA may surround the display area DA, on two or more sides thereof, and may define a periphery of the electronic device ED printed in a specific color.

The electronic device ED may include at least one sensor SN and at least one camera CA. The sensor SN and the camera CA may be adjacent to a periphery of the electronic device ED. The sensor SN and the camera CA may be disposed in the display area DA that is adjacent to the non-display area NDA. The sensor SN and the camera CA may be disposed in the second non-folding area NFA2, but the present invention is not necessarily limited thereto, and the sensor SN and the camera CA may be disposed in the first non-folding area NFA1.

Light may pass through portions of the electronic device ED, at which the sensor SN and the camera CA are disposed, and may be provided to the camera CA and the sensor SN. By way of example, the sensor SN may be a proximity light sensor, but the type of the sensor SN is not necessarily limited thereto. The camera CA may photograph an external image. A plurality of sensors SN and a plurality of cameras CA may be provided.

The electronic device ED may sense input applied from outside of the electronic device ED. For example, the electronic device ED may sense a first input through a touch of a user and a second input through a pen or stylus.

As used herein, the terms "pen" and "stylus may be used interchangeably and may mean a pointing device shaped as a pen and intended for use with such a display. The pointing device may have active and/or passive components that are used, in conjunction with the display, sense its presence and position with respect to the display device.

Referring to FIG. 2, the electronic device ED may be a foldable electronic device ED that is configured to be switched between folded and unfolded states. For example, the folding area FA may be bent with respect to a folding axis FX that is parallel to the second direction DR2, so that the electronic device ED may be folded.

When the electronic device ED is folded, the first non-folding area NFA1 and the second non-folding area NFA2 face each other, and the electronic device ED may be in-folded such that the display surface DS is not exposed to the outside and rather remains in a protected state. However, embodiments of the present invention are not necessarily limited thereto. For example, the electronic device ED may be out-folded about the folding axis FX such that the display surface DS is exposed to the outside and remains fully visible, even when folded.

A distance between the first non-folding area NFA1 and the second non-folding area NFA2 may be smaller than a diameter of a circle that is defined by a radius "R" of curvature of the folding area FA. In this case, the folding area FA may be folded in a dumbbell shape (e.g., a shape of a flat element ending into a rounded element), and the distance between the first non-folding area NFA1 and the second non-folding area NFA2 may become closer.

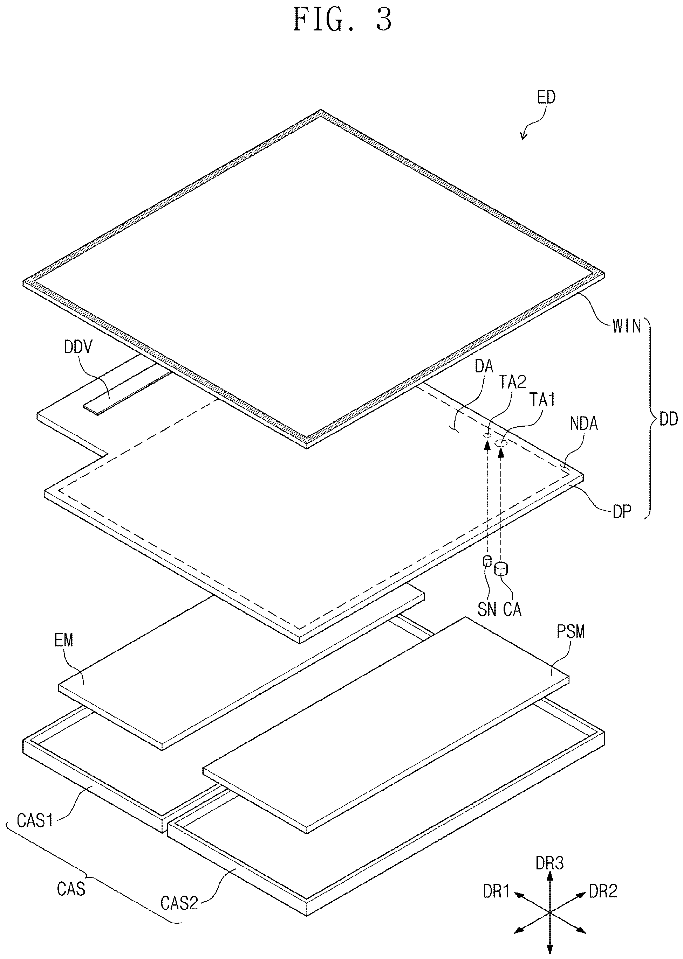

FIG. 3 is an exploded perspective view of the electronic device illustrated in FIG. 1.

Referring to FIG. 3, the electronic device ED may include a display device DD, a camera CA, a sensor SN, an electronic module EM, a power module PSM, and a case CAS.

The display device DD may include a window WIN and a display panel DP. Although the window WIN and the display panel DP in a stack structure of the display device DD are illustrated in FIG. 3 by way of example, the display device DD may further include various components, in addition to the window WIN and the display panel DP. A detailed stack structure of the display device DD will be described in detail below.

The window WIN may be disposed on the display panel DP to protect the display panel DP. The window WIN may transmit an image that is generated by the display panel DP to provide the image to a user. Thus, the window WIN may be substantially transparent to visible light and may offer shock and/or scratch resistance and protect the display panel DP from exposure to the ambient environment.

The display panel DP may include a display area DA and a non-display area NDA corresponding to the display area DA (see FIG. 1) and the non-display area NDA (see FIG. 1). In the specification, "an area/part and an area/part correspond to each other" means that they overlap each other, and might not be limited to the same extent.

A first transmission area TA1 and a second transmission area TA2 may be defined in the display panel DP. The first transmission area TA1 and the second transmission area TA2 may have a higher light transmittance than the surrounding areas. The camera CA may be disposed under the first transmission area TA1, and the sensor SN may be disposed under the second transmission area TA2. Light that passes through the first and second transmission areas TA1 and TA2 may be provided to the camera CA and the sensor SN.

The display device DD may include a data driver DDV that is disposed on the non-display area NDA of the display panel DP. The data driver DDV may be manufactured in the form of an integrated circuit chip, and may be mounted on a non-display area NDA. However, the present invention is not necessarily limited thereto, and the data driver DDV may be mounted on a flexible circuit board that is connected to the display panel DP.

The electronic module EM and the power module PSM may be disposed under the display panel DP. The electronic module EM and the power module PSM may be connected to each other through a separate flexible circuit board. The electronic module EM may control an operation of the display device DD. The power module PSM may supply electric power to the electronic module EM.

The case CAS may accommodate the display device DD, the electronic module EM, and the power module PSM. The case CAS may include a first case CAS1 and a second case CAS2 to fold the display device DD. The first case CAS1 and the second cases CAS2 may extend in the second direction DR2, and may be disposed in the first direction DR1.

The electronic device ED may further include a hinge structure for connecting the first and second cases CAS1 and CAS2 and rotating the first and second cases CAS1 and CAS2 so that the electronic device ED is folded. The case CAS may protect the display device DD, the electronic module EM, and the power module PSM.

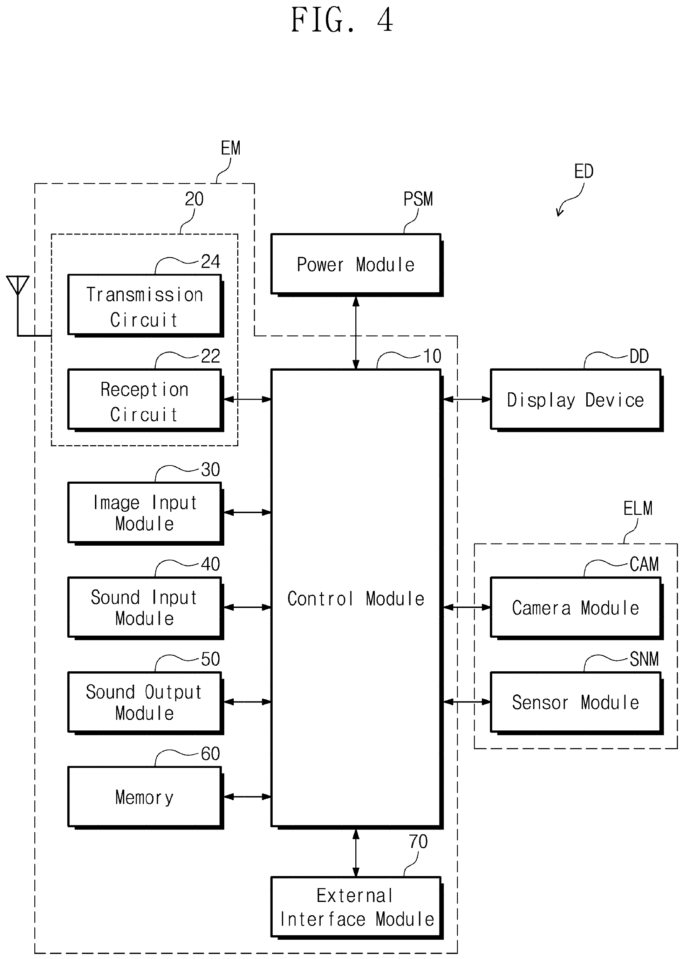

FIG. 4 is a block diagram of the electronic device illustrated in FIG. 3.

Referring to FIG. 4, the electronic device ED may include an electronic module EM, a power module PSM, a display device DD, and an electro-optical module ELM. The electronic module EM may include a control module 10, a wireless communication module 20, an image input module 30, a sound input module 40, a sound output module 50, a memory 60, and an external interface module 70. The modules may be mounted on a circuit board or may be electrically connected through a flexible circuit board. The electronic module EM may be electrically connected to the power module PSM.

The control module 10 may control an overall operation of the electronic device ED. For example, the control module 10 may activate or deactivate the display device DD according to a user input. The control module 10 may control the image input module 30, the sound input module 40, and the sound output module 50 according to a user input. The control module 10 may include at least one microprocessor.

The wireless communication module 20 may transmit/receive a wireless signal to/from other terminals by using a Bluetooth or Wi-Fi line. The wireless communication module 20 may transmit/receive a voice signal by using a general communication line. The wireless communication module 20 may include a transmission circuit 22 for modulating and transmitting a signal and a reception circuit 24 for demodulating a received signal.

The image input module 30 may process an image signal, and may convert the image signal into image data that may be displayed on the display device DD. The sound input module 40 may receive an external sound signal through a microphone in a recording mode or a voice recognition mode, and may convert the received sound signal into electrical voice data. The sound output module 50 may convert sound data received from the wireless communication module 20 or sound data stored in the memory 60, and may output the converted sound data to an external device.

The external interface module 70 may serve as an interface that is connected to an external charger, a wired/wireless data port, and a card socket (e.g., a memory card, or a SIM/UIM card).

The power module PSM may supply electric power that is required for the overall operation of the electronic device ED. The power module PSM may include a rechargeable battery device.

The electro-optical module ELM may be an electronic component that outputs or receives an optical signal. The electro-optical module ELM may transmit or receive an optical signal through a partial area of the display device DD. In an embodiment, the electro-optical module ELM may include a camera module CAM and a sensor module SNM. The camera module CAM may include the camera CA illustrated in FIG. 3. The sensor module SNM may include the sensor SN illustrated in FIG. 3.

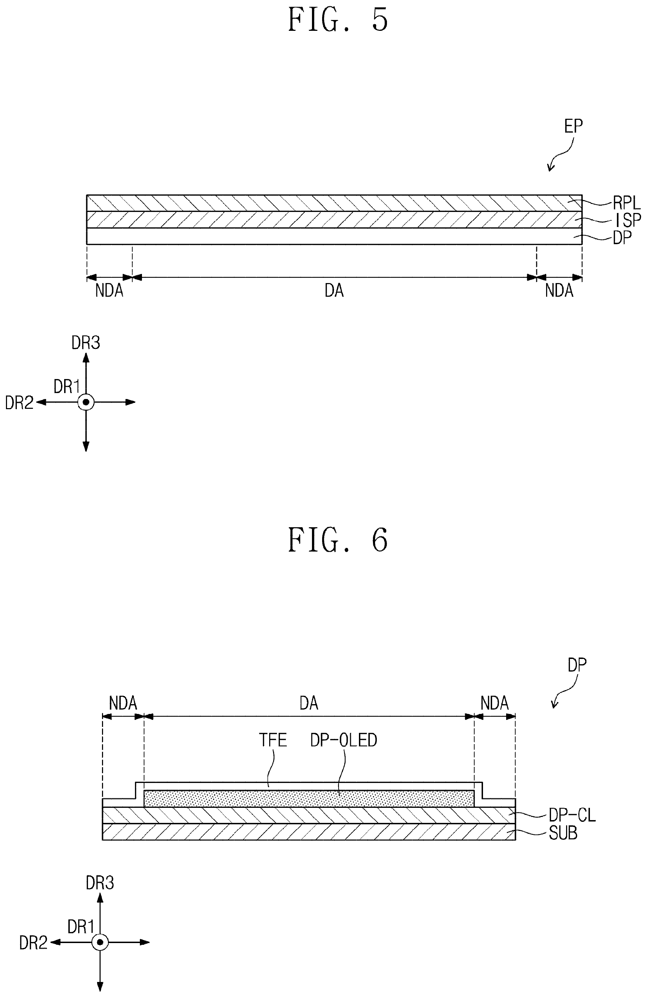

FIG. 5 is a view illustrating a cross section of an electronic panel including a display panel illustrated in FIG. 3 by way of example. FIG. 6 is a view illustrating a cross section of a display panel illustrated in FIG. 5 by way of example. The electronic panel is not shown in detail in FIG. 3, but only the display panel thereof.

By way of example, FIGS. 5 and 6 are illustrated as cross-sections viewed from the first direction DR1.

Referring to FIG. 5, an electronic panel EP may include a display panel DP, an input sensor ISP that is disposed on the display panel DP, and a reflection prevention layer RPL that is disposed on the input sensor ISP. The above-described display device DD may include an electronic panel EP.

The display panel DP may be a flexible display panel. The display panel DP, according to an embodiment of the present invention, may be a light emitting display panel. For example, the display panel DP may be an organic light emitting diode (OLED) display panel or an inorganic light emitting display panel. A light emission layer of the organic light emitting display panel may include an organic light emitting material. The light emission layer of the inorganic light emitting display panel may include a quantum dot, a quantum rod, and the like. Hereinafter, the display panel DP is described as an organic light emitting display panel.

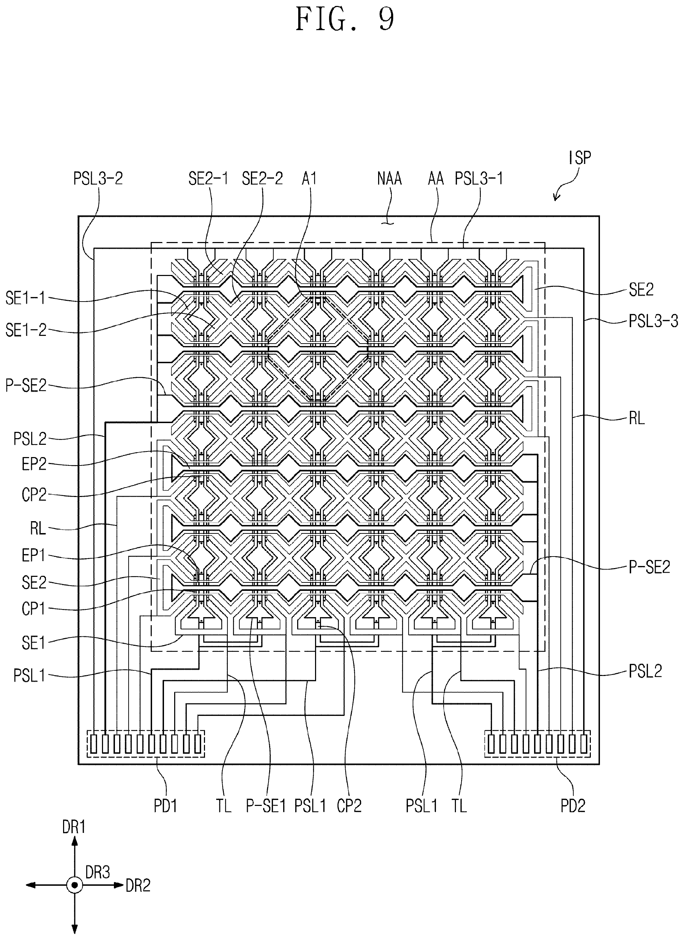

The input sensor ISP may include a plurality of sensing electrodes for sensing the first input described above in a capacitive manner. The input sensor ISP may include a plurality of pen sensing electrodes for sensing the second input described above in an electromagnetic manner. A more detailed configuration of the input sensor ISP will be illustrated in FIG. 9 below. The input sensor ISP may be formed directly on the display panel DP when the electronic panel EP is manufactured.

When the electronic panel EP is manufactured, the reflection prevention layer RPL may be manufactured directly on the input sensor ISP. However, the present invention is not necessarily limited thereto, and the reflection prevention layer RPL may be manufactured as a separate panel, and may be attached to the input sensor ISP by the adhesive layer.

The reflection prevention layer RPL may be defined as an external light reflection prevention film. The reflection prevention layer RPL may reduce a reflectance of external light that is input from the electronic device ED toward the display panel DP.

Referring to FIG. 6, the display panel DP may include a substrate SUB, a circuit element layer DP-CL that is disposed on the substrate SUB, a display element layer DP-OLED that is disposed on the circuit element layer DP-CL, and a thin film encapsulation layer TFE that is disposed on the display element layer DP-OLED.

The substrate SUB may include a display area DA and a non-display area NDA proximate to the display area DA. The substrate SUB may include a flexible plastic material such as glass or polyimide (PI). The display element layer DP-OLED may be disposed on the display area DA.

A plurality of pixels may be disposed on the circuit element layer DP-CL and the display element layer DP-OLED. Each of the pixels may include transistors that are disposed on the circuit element layer DP-CL, and a light emitting element disposed on the display element layer DP-OLED and is connected to the transistors.

The thin film encapsulation layer TFE may be disposed on the circuit element layer DP-CL and covers the display element layer DP-OLED. The thin film encapsulation layer TFE may protect the pixels from moisture, oxygen, and external foreign substances.

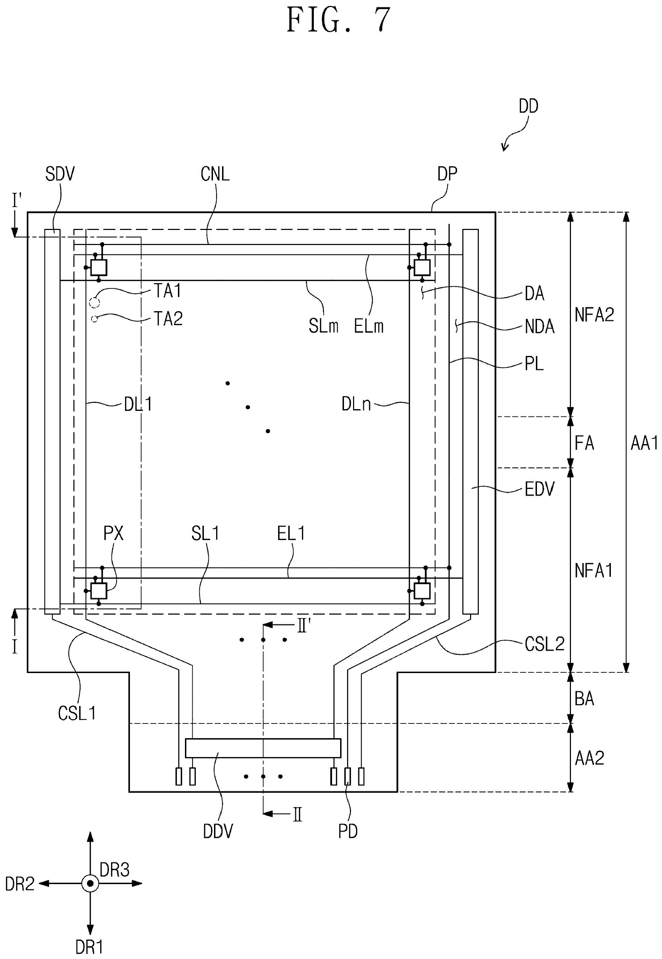

FIG. 7 is a plan view of a display panel illustrated in FIG. 3.

Referring to FIG. 7, the display device DD may include a display panel DP, a scan driver SDV, a data driver DDV, and a light emission driver EDV.

The display panel DP may include a first area AA1, a second area AA2, and a bending area BA between the first area AA1 and the second area AA2. The first area AA1, the bending area BA, and the second area AA2 may be arranged in the first direction DR1.

The first area AA1 may include a display area DA and a non-display area NDA proximate to the display area DA. The non-display area NDA may surround the display area DA at least on two opposing sides thereof. The display area DA may be an area that displays an image, and the non-display area NDA may be an area that does not displaying an image. The second area AA2 and the bending area BA may be areas that do not display an image.

When viewed from the second direction DR2, the first area AA1 may include a first non-folding area NFA1, a second non-folding area NFA2, and a folding area FA between the first non-folding area NFA1 and the second non-folding area NFA2. The first non-folding area NFA1 and the second non-folding area NFA2, and the folding area FA may correspond to the first non-folding area NFA1 and the second non-folding area NFA2, and the folding area FA of the electronic device ED illustrated in FIG. 1. The first transmission area TA1 and the second transmission area TA2 may be defined in the display area DA and the second non-folding area NFA2.

The first area AA1 may be bent and folded with respect to the folding axis FX described above. For example, when the folding area FA of the first area AA1 is folded with respect to the folding axis FX described above, the display panel DP may be folded.

The display panel DP may include a plurality of pixels PX, a plurality of scan lines SL1 to SLm, a plurality of data lines DL1 to DLn, a plurality of light emission lines EL1 to ELm, first and second control lines CSL1 and CSL2, a plurality of connection lines CNL, and a plurality of pads PD. Here, "m" and "n" are positive integers. The pixels PX are disposed in the display area DA, and may be connected to the scan lines SL1 to SLm, the data lines DL1 to DLn, and the light emission lines EL1 to ELm.

The scan driver SDV and the light emission driver EDV may be disposed in a non-display area NDA. The scan driver SDV and the light emission driver EDV may be disposed in non-display areas NDA that are adjacent to opposite sides of the first area AA1, which are opposite to each other in the second direction DR2. The data driver DDV may be disposed in the second area AA2. The data driver DDV may be manufactured in the form of an integrated circuit chip, and may be mounted on the second area AA2.

The scan lines SL1 to SLm may extend in the second direction DR2, and may be connected to the scan driver SDV. The data lines DL1 to DLn may extend in the first direction DR1, and may be connected to the data driver DDV through the bending area BA. The data driver DDV may be connected to the pixels PX through the data lines DL1 to DLn. The light emission lines EL1 to ELm may extend in the second direction DR2, and may be connected to the light emission driver EDV.

A power line PL may extend in the first direction DR1, and may be disposed in the non-display area NDA. The power line PL may be disposed between the display area DA and the light emission driver EDV. The power line PL may extend to the second area AA2 through the bending area BA. In a plan view, the power line PL may extend toward a lower end of the second area AA2. The power line PL may receive a driving voltage.

The connection lines CNL may extend in the second direction DR2, and may be arranged in the first direction DR1. The connection lines CNL may be connected to the power line PL and the pixels PX. The driving voltage may be applied to the pixels PX through the power line PL and the connection lines CNL that are connected to each other.

A first control line CSL1 may be connected to the scan driver SDV, and may extend toward a lower end of the second area AA2 via the bending area BA. A second control line CSL2 may be connected to the light emission driver EDV, and may extend toward a lower end of the second area AA2 via the bending area BA. The data driver DDV may be disposed between the first control line CSL1 and the second control line CSL2.

In a plan view, the pads PD may be disposed adjacent to a lower end of the second area AA2. The data driver DDV, the power line PL, the first control line CSL1, and the second control line CSL2 may be connected to the pads PD.

The data lines DL1 to DLn may be connected to corresponding pads PD through the data driver DDV. For example, the data lines DL1 to DLn may be connected to the data driver DDV, and the data driver DDV may be connected to pads PD corresponding to the data lines DL1 to DLn, respectively.

A printed circuit board may be connected to the pads PD, and a timing controller and a voltage generator may be disposed on the printed circuit board. The timing controller may be manufactured from an integrated circuit chip, and may be mounted on the printed circuit board. The timing controller and the voltage generator may be connected to the pads PD through the printed circuit board.

The timing controller may control operations of the scan driver SDV, the data driver DDV, and the light emission driver EDV. The timing controller may generate a scan control signal, a data control signal, and a light emission control signal in response to control signals received from an external source. The voltage generator may generate a driving voltage.

The scan control signal may be provided to the scan driver SDV through the first control line CSL1. The light emission control signal may be provided to the light emission driver EDV through the second control line CSL2. The data control signal may be provided to the data driver DDV. The timing controller may receive image signals from an external source, may convert a data format of the image signals such that the data format matches a specification of an interface with the data driver DDV, and may provide the converted data format to the data driver DDV.

The scan driver SDV may generate a plurality of scan signals in response to a scan control signal. The scan signals may be applied to the pixels PX through the scan lines SL1 to SLm. The scan signals may be sequentially applied to the pixels PX.

The data driver DDV may generate a plurality of data voltages corresponding to the image signals in response to the data control signal. The data voltages may be applied to the pixels PX through data lines DL1 to DLn. The light emission driver EDV may generate a plurality of light emission signals in response to the light emission control signal. The light emission signals may be applied to the pixels PX through the light emission lines EL1 to ELm.

The pixels PX may receive data voltages in response to scan signals. The pixels PX may display an image by emitting light having a luminance corresponding to data voltages in response to light emission signals. The light emission time of the pixels PX may be controlled by the light emission signals.

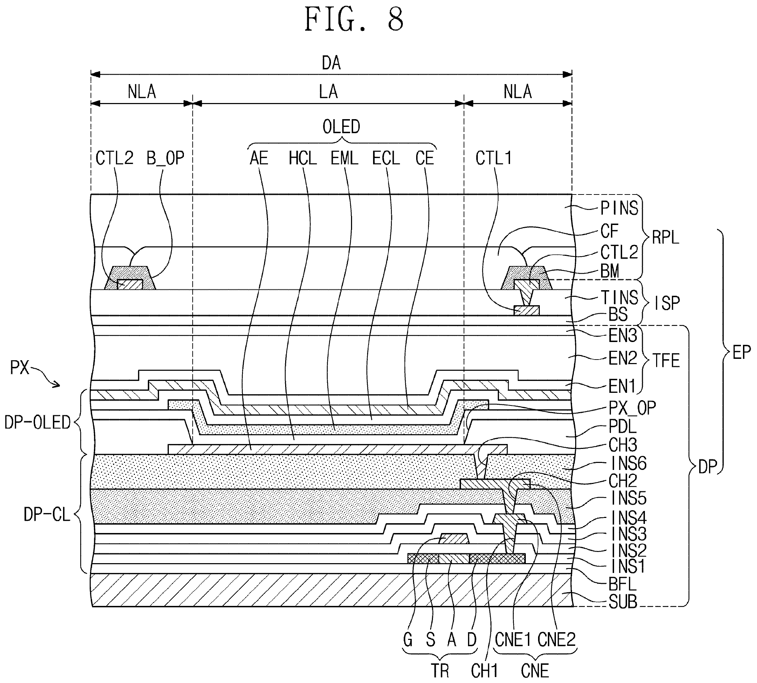

FIG. 8 is a view illustrating a cross section of an electronic panel corresponding to any one pixel illustrated in FIG. 7 by way of example.

Referring to FIG. 8, the display panel DP may include a pixel PX, and the pixel PX may include a transistor TR and a light emitting element OLED. The light emitting element OLED may include a first electrode AE (or an anode), a second electrode CE (or a cathode), a hole control layer HCL, an electronic control layer ECL, and a light emission layer EML.

The transistor TR and the light emitting element OLED may be disposed on the substrate SUB. Although one transistor TR is illustrated by way of example, the pixel PX may include a plurality of transistors and at least one capacitor for driving the light emitting element OLED.

The display area DA may include a light emission area LA corresponding to each of the pixels PX and a non-light emission area NLA proximate to the light emission area LA. The light emitting element OLED may be disposed in the light emission area LA.

A buffer layer BFL is disposed on the substrate SUB, and the buffer layer BFL may be an inorganic layer. A semiconductor pattern may be disposed on the buffer layer BFL. The semiconductor pattern may include polysilicon, amorphous silicon, or metal oxide.

The semiconductor pattern may be doped with an N-type dopant or a P-type dopant. The semiconductor pattern may include a high-doped area and a low-doped area. A conductivity of the high-doped area may be greater than that of the low-doped area, and may substantially serve as a source electrode and a drain electrode of the transistor TR. The low-doped area may substantially correspond to an active (or channel) of the transistor.

The source "S", the active "A", and the drain "D" of the transistor TR may be formed from a semiconductor pattern. A first insulation layer INS1 may be disposed on the semiconductor pattern. A gate "G" of the transistor TR may be disposed on the first insulation layer INS1. A second insulation layer INS2 may be disposed on the gate "G". A third insulation layer INS3 may be disposed on the second insulation layer INS2.

A connection electrode CNE may include a first connection electrode CNE1 and a second connection electrode CNE2 to connect the transistor TR to the light emitting element OLED. The first connection electrode CNE1 may be disposed on the third insulation layer INS3, and may be connected to the drain "D" through first contact holes CH1 defined in the first to third insulation layers INS1 to INS3.

A fourth insulation layer INS4 may be disposed on the first connection electrode CNE1. A fifth insulation layer INS5 may be disposed on the fourth insulation layer INS4. The second connection electrode CNE2 may be disposed on the fifth insulation layer INS5. The second connection electrode CNE2 may be connected to the first connection electrode CNE1 through second contact holes CH2 defined in the fourth and fifth insulation layers INS4 and INS5.

A sixth insulation layer INS6 may be disposed on the second connection electrode CNE2. The layers from the buffer layer BFL to the sixth insulation layer INS6 may be defined as a circuit element layer DP-CL. The first to sixth insulation layers INS1 to INS6 may be inorganic layers or organic layers.

A first electrode AE may be disposed on the sixth insulation layer INS6. The first electrode AE may be connected to the second connection electrode CNE2 through a third contact hole CH3 defined in the sixth insulation layer INS6. A pixel definition layer PDL, in which an opening PX_OP for exposing a specific portion of the first electrode AE is defined, may be disposed on the first electrode AE and the sixth insulation layer INS6.

The hole control layer HCL may be disposed on the first electrode AE and the pixel definition layer PDL. The hole control layer HCL may include a hole transport layer and a hole injection layer.

The light emission layer EML may be disposed on the hole control layer HCL. The light emission layer EML may be disposed in an area corresponding to the opening PX_OP. The light emission layer EML may include an organic material and/or an inorganic material. The light emission layer EML may generate any one of red, green, and blue light.

An electron control layer ECL may be disposed on the light emission layer EML and the hole control layer HCL. The electron control layer ECL may include an electron transport layer and an electron injection layer. The hole control layer HCL and the electron control layer ECL may be disposed in common in the light emission area LA and the non-light emission area NLA.

The second electrode CE may be disposed on the electronic control layer ECL. The second electrode CE may be disposed in common on the pixels PX. The layer, on which the light emitting element OLED is disposed, may be defined as a display element layer DP-OLED.

The thin film encapsulation layer TFE may be disposed on the second electrode CE and covers the pixel PX. The thin film encapsulation layer TFE may include a first encapsulation layer EN1 that is disposed on the second electrode CE, a second encapsulation layer EN2 that is disposed on the first encapsulation layer EN1, and a third encapsulation layer EN3 that is disposed on the second encapsulation layer EN2.

The first encapsulation layer EN1 and third encapsulation layer EN3 may include an inorganic insulation layer, and may protect the pixel PX from moisture/oxygen. The second encapsulation layer EN2 may include an organic insulation layer, and may protect the pixel PX from foreign substances, such as dust particles.

A first voltage may be applied to the first electrode AE through the transistor TR, and a second voltage having a level that is lower than the first voltage may be applied to the second electrode CE. Holes and electrons that are injected into the light emission layer EML are coupled to form excitons, and the light emitting element OLED may emit light while the excitons transition to a ground state.

Layers from the substrate SUB to the thin film encapsulation layer TFE may be defined as the display panel DP. An input sensor ISP may be disposed on the thin film encapsulation layer TFE. The input sensor ISP may be manufactured directly on an upper surface of the thin film encapsulation layer TFE.

A base layer BS may be disposed on the thin film encapsulation layer TFE. The base layer BS may include an inorganic insulation layer. At least one inorganic insulation layer may be provided on the thin film encapsulation layer TFE as the base layer BS.

The input sensor ISP may include a first conductive pattern CTL1 and a second conductive pattern CTL2 that is disposed on the first conductive pattern CTL1. The first conductive pattern CTL1 may be disposed on the base layer BS. An insulation layer TINS may be disposed on the base layer BS and covers the first conductive pattern CTL1. The insulation layer TINS may include an inorganic insulation layer or an organic insulation layer. The second conductive pattern CTL2 may be disposed on the insulation layer TINS.

The first conductive pattern CTL1 and the second conductive pattern CTL2 may overlap the non-light emission area NLA. The first conductive pattern CTL1 and the second conductive pattern CTL2 may be disposed on the non-light emission area NLA between the light emission areas LA, and may have a mesh shape.

The first conductive pattern CTL1 and the second conductive pattern CTL2 may form sensing electrodes and pen sensing electrodes of the input sensor ISP described above. For example, the first conductive pattern CTL1 and the second conductive pattern CTL2 of the mesh shape may be separated from each other in a specific area to form sensing electrodes and pen sensing electrodes. A portion of the second conductive pattern CTL2 may be connected to the first conductive pattern CTL1.

The reflection prevention layer RPL may be disposed on the second conductive pattern CTL2. The reflection prevention layer RPL may include a black matrix BM and a plurality of color filters CF. The black matrix BM may overlap the non-light emission area NLA, and the color filters CF may overlap the light emission areas LA, respectively.

The black matrix BM may be disposed on the insulation layer TINS and may cover the second conductive pattern CTL2. In the black matrix BM, a light emission area LA and an opening B_OP that overlaps the opening PX_OP may be defined. The black matrix BM may absorb and block light. A width of the opening B_OP may be greater than a width of the opening PX_OP.

The color filters CF may be disposed on the insulation layer TINS and the black matrix BM. The color filters CF may be disposed on the openings B_OP, respectively. A planarization insulation layer PINS may be disposed on the color filters CF. The planarization insulation layer PINS may provide a flat upper surface.

When external light that travels toward the display panel DP is reflected from the display panel DP and provided to an external user again, the user may visually recognize the external light, like a mirror. To prevent the phenomenon, by way of example, the reflection prevention layer RPL may include color filters CF that display the same color as that of the pixels PX of the display panel DP. The color filters CF may filter the external light with the same colors as that of the pixels PX. In this case, the external light might not be visually recognized by the user.

However, an embodiment of the present invention is not necessarily limited thereto, and the reflection prevention layer RPL may include a polarizing film to reduce the reflectance of the external light. The polarizing film may be separately manufactured, and may be attached to the input sensor ISP by an adhesive layer. The polarizing film may include a retarder and/or a polarizer.

FIG. 9 is a plan view of an input sensor illustrated in FIG. 5.

Referring to FIG. 9, the input sensor ISP may include a plurality of sensing electrodes SE1 and SE2, a plurality of sensing lines TL and RL, a plurality of pen sensing electrodes P-SE1 and P-SE2, a plurality of pen sensing lines PSL1, PSL2, and PSL3-1 to PSL3-3, a plurality of first pads PD1, and a plurality of second pads PD2. The sensing electrodes SE1 and SE2, the sensing lines TL and RL, the pen sensing electrodes P-SE1 and P-SE2, the pen sensing lines PSL1, PSL2, and PSL3-1 to PSL3-3, and the first and second pads PD1 and PD2 may be disposed on the thin film encapsulation layer TFE described above.

A planar area of the input sensor ISP may include an active area AA and an inactive area NAA proximate to the active area AA. In a plan view, the active area AA may overlap the above-described display area DA, and the inactive area NAA may overlap the above-described non-display area NDA. As used herein, the phrase "overlap" may mean at least a partial overlapping or may mean that all of the sides align from layer to layer and fully correspond to one another.

The sensing electrodes SE1 and SE2 may be disposed in the active area AA, and the first pads PD1 and the second pads PD2 may be disposed in the inactive area NAA. The first pads PD1 and the second pads PD2 may be adjacent to a lower end of the input sensor ISP in a plan view. By way of example, the first pads PD1 may be disposed adjacent to the left side of the input sensor ISP, and the second pads PD2 may be disposed adjacent to the right side of the input sensor ISP.

The sensing electrodes SE1 and SE2 may include a plurality of first sensing electrodes SE1 that extend in the first direction DR1 and are arranged in the second direction DR2, and a plurality of second sensing electrodes SE2 that extend in the second direction DR2 and are arranged in the first direction DR1. The second sensing electrodes SE2 may be insulated from the first sensing electrodes SE1 and extend to cross each other. The first sensing electrodes SE1 and the second sensing electrodes SE2 may be used to sense the first input described above.

The sensing lines TL and RL may be connected to ends of the first and second sensing electrodes SE1 and SE2, and may extend to the inactive area NAA to be connected to the first and second pads PD1 and PD2. The sensing lines TL and RL may include a plurality of first sensing lines TL that are connected to the first sensing electrodes SE1, and a plurality of second sensing lines RL that are connected to the second sensing electrodes SE2.

The first sensing lines TL may be connected to lower ends of the first sensing electrodes SE1. The first sensing lines TL may extend to the inactive area NAA, and may be connected to corresponding first and second pads PD1 and PD2.

The input sensor ISP may be divided into a left portion and a right portion with respect to a center in the second direction DR2. The first sensing lines TL connected to the first sensing electrodes SE1 disposed at the left portion may be connected to corresponding first pads PD1. The first sensing lines TL connected to the first sensing electrodes SE1 disposed at the right portion may be connected to corresponding second pads PD2.

The second sensing lines RL may be connected to the left ends or the right ends of the second sensing electrodes SE2. The second sensing lines RL may extend to the inactive area NAA, and may be connected to corresponding first and second pads PD1 and PD2.

The input sensor ISP may be divided into a lower portion and an upper portion with respect to a center in the first direction DR1. The second sensing lines RL disposed under the input sensor ISP may be connected to left ends of the second sensing electrodes SE2 disposed under the input sensor ISP. The second sensing lines RL disposed on the input sensor ISP may be connected to right ends of the second sensing electrodes SE2 disposed on the input sensor ISP.

The second sensing lines RL disposed under the input sensor ISP may be connected to corresponding first pads PD1. The second sensing lines RL disposed on the input sensor ISP may be connected to corresponding second pads PD2.

Each of the first sensing electrodes SE1 may include a (1-1)-th sensing electrode SE1-1 and a (1-2)-th sensing electrode SE1-2 that extend in the first direction DR1 and are spaced apart from each other in the second direction DR2. The (1-1)-th sensing electrode SE1-1 and the (1-2)-th sensing electrode SE1-2 may have shapes that are symmetrical to each other in the second direction DR2.

In each of the first sensing electrodes SE1, a lower end of the (1-1)-th sensing electrode SE1-1 and a lower end of the (1-2)-th sensing electrode SE1-2 may be connected to a corresponding one of the first sensing lines TL. In each of the first sensing electrodes SE1, an upper end of the (1-1)-th sensing electrode SE1-1 and an upper end of the (1-2)-th sensing electrode SE1-2 might not be connected to each other.

Each of the second sensing electrodes SE2 may include a (2-1)-th sensing electrode SE2-1 and a (2-2)-th sensing electrode SE2-2 that extend in the second direction DR2 and are spaced apart in the first direction DR1. The (2-1)-th sensing electrode SE2-1 and the (2-2)-th sensing electrode SE2-2 may have shapes that are symmetrical to each other in the first direction DR1.

In each of the second sensing electrodes SE2 disposed under the input sensor ISP, a left end of the (2-1)-th sensing electrode SE2-1 and a left end of the (2-2)-th sensing electrode SE2-2 may be connected to a corresponding one of the second sensing lines RL. In each of the second sensing electrodes SE2 disposed under the input sensor ISP, a right end of the (2-1)-th sensing electrode SE2-1 and a right end of the (2-2)-th sensing electrode SE2-2 might not be connected to each other.

In each of the second sensing electrodes SE2 disposed on the input sensor ISP, a right end of the (2-1)-th sensing electrode SE2-1 and a right end of the (2-2)-th sensing electrode SE2-2 may be connected to a corresponding one of the second sensing lines RL. In each of the second sensing electrodes SE2 disposed on the input sensor ISP, a left end of the (2-1)-th sensing electrode SE2-1 and a left end of the (2-2)-th sensing electrode SE2-2 might not be connected to each other.

By way of example, in a plan view, the first sensing lines TL may be disposed in an inactive area NAA that is adjacent to a lower side of the active area AA. Furthermore, in a plan view, the second sensing lines RL may be disposed in the inactive area NAA that are adjacent to the left and right sides of the active area AA.

The pen sensing electrodes P-SE1 and P-SE2 may be disposed in the active area AA. The pen sensing lines PSL1, PSL2, and PSL3-1 to PSL3-3 may be connected to the pen sensing electrodes P-SE1 and P-SE2 to extend to the inactive area NAA, and may be connected to corresponding first and second pads PD1 and PD2.

A sensing IC for controlling the input sensor ISP may be connected to the first and second pads PD1 and PD2 through a printed circuit board.

The pen sensing electrodes P-SE1 and P-SE2 may include a plurality of first pen sensing electrodes P-SE1 that extend in the first direction DR1 and are arranged in the second direction DR2, and a plurality of second pen sensing electrodes P-SE2 that extend in the second direction DR2 and are arranged in the first direction DR1. The first and second pen sensing electrodes P-SE1 and P-SE2 may be used to sense the second input described above.

The second pen sensing electrodes P-SE2 may be insulated from and extend to cross the first pen sensing electrodes P-SE1. The first pen sensing electrodes P-SE1 may be insulated from and extend to cross the second sensing electrodes SE2. The second pen sensing electrodes P-SE2 may be insulated from and extend to cross the first sensing electrodes SE1.

Each of the first pen sensing electrodes P-SE1 may be disposed between the (1-1)-th sensing electrode SE1-1 and the (1-2)-th sensing electrode SE1-2 of a corresponding one of the first sensing electrodes SE1. Each of the second pen sensing electrodes P-SE2 may be disposed between the (2-1)-th sensing electrode SE2-1 and the (2-2)-th sensing electrode SE2-2 of a corresponding one of the second sensing electrodes SE2.

The sensing electrodes SE1 and SE2 and the pen sensing electrodes P-SE1 and P-SE2 may be simultaneously patterned through the same process to be formed on the same layer. The sensing electrodes SE1 and SE2 and the pen sensing electrodes P-SE1 and P-SE2 may be formed by patterning the same electrode. For example, the sensing electrodes SE1 and SE2 and the pen sensing electrodes P-SE1 and P-SE2 may be formed by the first conductive pattern CTL1 and the second conductive pattern CTL2 described above.

The first pen sensing electrodes P-SE1 may be disposed on the same layer as the first sensing electrodes SE1. The second pen sensing electrodes P-SE2 may be disposed on the same layer as the second sensing electrodes SE2. The first pen sensing electrodes P-SE1, the first sensing electrodes SE1, the second pen sensing electrodes P-SE2, and the second sensing electrodes SE2 may all be disposed on the same layer.

Upper ends of the first pen sensing electrodes P-SE1 may be connected to each other. Lower ends of the first pen sensing electrodes P-SE1 may be connected to each other in a pair. Left ends of the second pen sensing electrodes P-SE2 disposed on the input sensor ISP may be connected to each other. Right ends of the second pen sensing electrodes P-SE2 disposed under the input sensor ISP may be connected to each other.

Right ends of the second pen sensing electrodes P-SE2 disposed on the input sensor ISP might not be connected to each other. Left ends of the second pen sensing electrodes P-SE2 disposed under the input sensor ISP might not be connected to each other.

The pen sensing lines PSL1, PSL2, and PSL3-1 to PSL3-3 may include a plurality of first pen sensing lines PSL1, a plurality of second pen sensing lines PSL2, and a plurality of (3-1)-th to (3-3)-th pen sensing lines PSL3-1, PSL3-2, and PSL3-3. The first pen sensing lines PSL1 and the (3-1)-th, (3-2)-th, and (3-3)-th pen sensing lines PSL3-1, PSL3-2, and PSL3-3 may be connected to the first pen sensing electrodes P-SE1. The second pen sensing lines PSL2 may be connected to the second pen sensing electrodes P-SE2.

A pair of first pen sensing electrodes P-SE1, of which lower ends are connected to each other, may be connected to a corresponding one of the first pen sensing lines PSL1. Upper ends of the first pen sensing electrodes P-SE1 may be connected to a (3-1)-th pen sensing line PSL3-1 that extends in the second direction DR2.

The (3-2)-th pen sensing line PSL3-2 and the (3-3)-th pen sensing line PSL3-3 may extend from opposite ends of the (3-1)-th pen sensing line PSL3-1 in the first direction DR1. The (3-2)-th pen sensing line PSL3-2 may be disposed on the left side of the input sensor ISP, and may be connected to a corresponding first pad PD1. The (3-3)-th pen sensing line PSL3-3 may be disposed on the right side of the input sensor ISP, and may be connected to a corresponding second pad PD2.

Left ends of the second pen sensing electrodes P-SE2 disposed on the input sensor ISP may be connected to a corresponding one of the second pen sensing lines PSL2. The second pen sensing line PSL2 connected to the second pen sensing electrodes P-SE2 disposed on the input sensor ISP may be connected to a corresponding first pad PD1.

Right ends of the second pen sensing electrodes P-SE2 disposed under the input sensor ISP may be connected to a corresponding one of the second pen sensing lines PSL2. The second pen sensing line PSL2 connected to the second pen sensing electrodes P-SE2 disposed under the input sensor ISP may be connected to a corresponding second pad PD2.

By way of example, the input sensor ISP may be driven in a time division manner to be driven in a first sensing section and a second sensing section. The first sensing section and the second sensing section may be repeated. During the first sensing section, the first sensing electrode SE1 and the second sensing electrode SE2 may be driven so that a first input through a touch of the user may be sensed. During the second sensing section, a second input through a touch of a pen may be sensed by the first pen sensing electrode P-SE1 and the second pen sensing electrode P-SE2. An operation of sensing a touch of a pen will be described in detail below.

Because the touch of the user and the touch of the pen are performed in the same input sensor ISP, two input devices, such as a touch panel and a digitizer, are not used, and thus a thickness of the display device DD may be reduced.

Although six first pen sensing electrodes P-SE1 and six second pen sensing electrodes P-SE2 are illustrated by way of examples, the input sensor ISP may include more first pen sensing electrodes P-SE1 and more second pen sensing electrodes P-SE2.

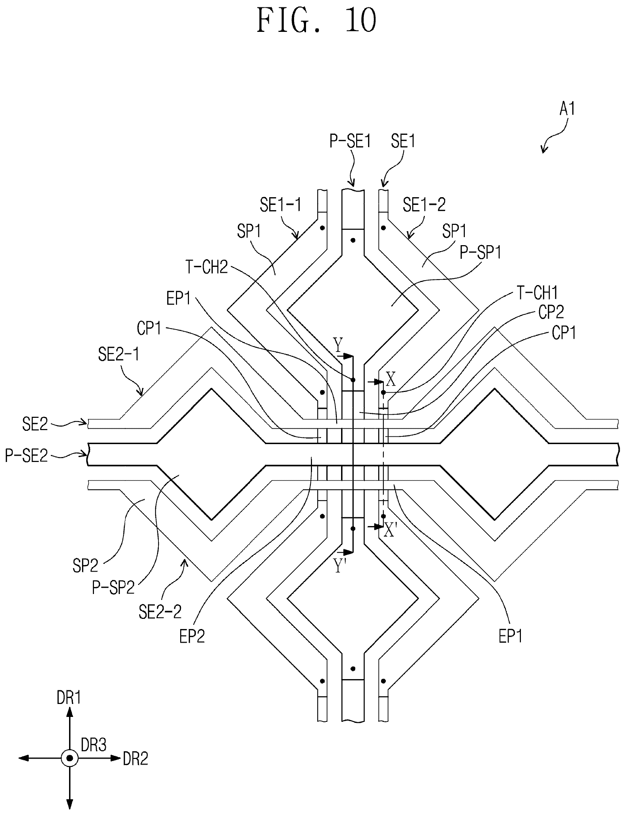

FIG. 10 is an enlarged view of a first area A1 illustrated in FIG. 9.

Referring to FIGS. 9 and 10, each of the (1-1)-th and (1-2)-th sensing electrodes SE1-1 and SE1-2 may include a plurality of first sensors SP1 that are arranged in the first direction DR1 and a plurality of first connection patterns CP1 that connect the first sensors SP1.

The first sensors SP1 may have a bent shape. For example, the first sensors SP1 of the (1-1)-th sensing electrode SE1-1 and the first sensors SP1 of the (1-2)-th sensing electrode SE1-2 may have shapes that are bent toward the outside.

The first connection patterns CP1 may extend in the first direction DR1. Each of the first connection patterns CP1 may be disposed between two first sensors SP1 that are adjacent to each other in the first direction DR1 to connect the two first sensors SP1. An insulation layer may be disposed between the first connection patterns CP1 and the first sensors SP1, and the first connection patterns CP1 may be connected to the first sensors SP1 through first contact holes T-CH1 defined in the insulation layer.

Each of the (2-1)-th and (2-2)-th sensing electrodes SE2-1 and SE2-2 may include a plurality of second sensors SP2 that are arranged in the second direction DR2 and a plurality of first extension patterns EP1 that extend in the second direction DR2 from the second sensors SP2. In a plan view, the first extension patterns EP1 may extend to cross the first connection patterns CP1.

The second sensors SP2 may have a bent shape. For example, the second sensors SP2 of the (2-1)-th sensing electrode SE2-1 and the second sensors SP2 of the (2-2)-th sensing electrode SE2-2 may have a shape that is bent toward the outside.

In each of the (2-1)-th and (2-2)-th sensing electrodes SE2-1 and SE2-2, the first extension patterns EP1 may be integrally formed with the second sensors SP2. Each of the first extension patterns EP1 may be disposed between two second sensors SP2 that are adjacent to each other in the second direction DR2, and may extend from the two second sensors SP2.

The first sensors SP1 and the second sensors SP2 may be spaced apart from each other without overlapping each other, and may be alternately disposed. Capacitances may be formed by the first sensors SP1 and the second sensors SP2.

The first and second sensors SP1 and SP2 and the first extension patterns EP1 may be disposed on the same layer. The first connection patterns CP1 may be disposed on a different layer from the first and second sensors SP1 and SP2 and the first extension patterns EP1. For example, the first connection patterns CP1 may be disposed under the first and second sensors SP1 and SP2 and the first extension patterns EP1.

Each of the first pen sensing electrodes P-SE1 may include a plurality of first pen sensors P-SP1 that are arranged in the first direction DR1 and a plurality of second connection patterns CP2 that connect the first pen sensors P-SP1. The first pen sensors P-SP1 may have a rhombus shape, but the shape of the first pen sensors P-SP1 is not necessarily limited thereto.

The second connection patterns CP2 may extend in the first direction DR1. Each of the second connection patterns CP2 may be disposed between two first pen sensors P-SP1 that are adjacent to each other in the first direction DR1, and may connect the two first pen sensors P-SP1. An insulation layer may be disposed between the second connection patterns CP2 and the first pen sensors P-SP1, and the second connection patterns CP2 may be connected to the first pen sensors P-SP1 through second contact holes T-CH2 defined in the insulation layer.

Each of the second pen sensing electrodes P-SE2 may include a plurality of second pen sensors P-SP2 that are arranged in the second direction DR2 and a plurality of second extension patterns EP2 that extend in the second direction DR2 from the second pen sensors P-SP2. In a plan view, the first and second extension patterns EP1 and EP2 may extend to cross the first and second connection patterns CP1 and CP2.

The second pen sensors P-SP2 may have a rhombus shape, but the shape of the second pen sensors P-SP2 is not necessarily limited thereto. The second extension patterns EP2 may be integrally formed with the second pen sensors P-SP2. Each of the second extension patterns EP2 may be disposed between two second pen sensors P-SP2 that are adjacent to each other in the second direction DR2, and may extend from two second pen sensors P-SP2.

The first pen sensors P-SP1, the second pen sensors P-SP2, and the second extension patterns EP2 may be disposed in the same layer as the first and second sensors SP1 and SP2 and the first extension patterns EP1. The second connection patterns CP2 may be disposed in the same layer as the first connection patterns CP1.

In FIG. 9, the first sensing lines TL1 and the first pen sensing lines PSL1 may be insulated from each other, and may extend to cross each other. For example, referring to FIGS. 9 and 10, the first sensing lines TL1 may be integrally formed with the first sensors SP1 that are adjacent to a lower side of the active area AA, and may extend from the first sensors SP1. The first pen sensing lines PSL1 may be integrally formed with the second connection patterns CP2 that is adjacent to a lower side of the active area AA, and may extend from the second connection patterns CP2.

In FIG. 9, the first pen sensing lines PSL1 may be disposed under the first sensing lines TL1. An insulation layer may be disposed between the first pen sensing lines PSL1 and the first sensing lines TL1.

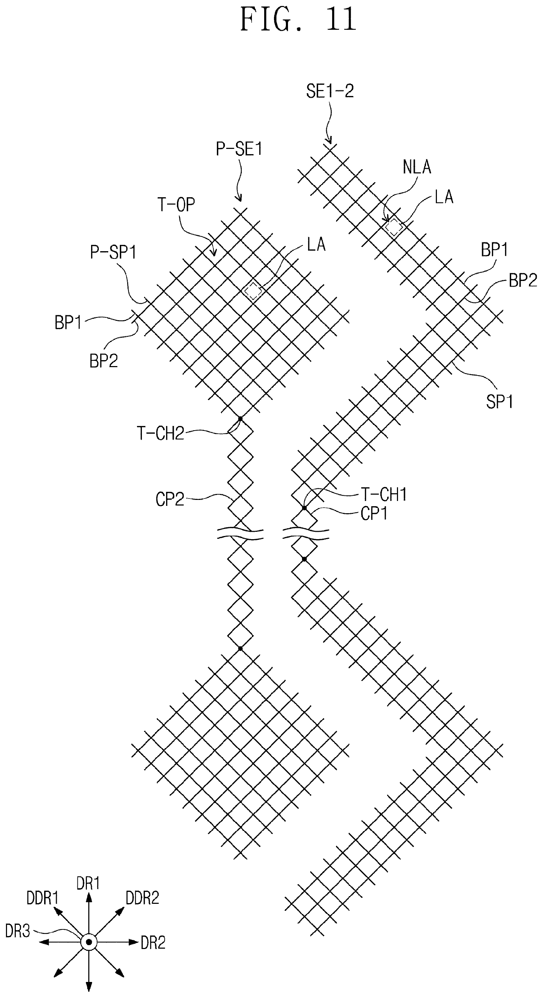

FIG. 11 is a view illustrating a detailed configuration of a first pen sensing electrode and the (1-2)-th sensing electrode illustrated in FIG. 10.

Referring to FIG. 11, the first pen sensing electrode P-SE1 and the (1-2)-th sensing electrode SE1-2 may have mesh shapes. For example, each of the first pen sensing electrode P-SE1 and the (1-2)-th sensing electrode SE1-2 may include a plurality of first branches BP1 that extend in a first diagonal direction DDR1 and a plurality of second branches BP2 that extend in a second diagonal direction DDR2.

The first diagonal direction DDR1 may be defined as a direction that crosses the first and second directions DR1 and DR2 on the plane defined by the first and second directions DR1 and DR2. The second diagonal direction DDR2 may be defined as a direction that crosses the first diagonal direction DDR1 on the plane defined by the first and second directions DR1 and DR2.

The first and second branches BP1 and BP2 may may be integrally formed while crossing each other. The mesh shapes of the first pen sensing electrode P-SE1 and the (1-2)-th sensing electrode SE1-2 may be defined by the first and second branches BP1 and BP2.

The (1-1)-th sensing electrode SE1-1, the second pen sensing electrode P-SE2, and the (2-1)-th and (2-2)-th sensing electrodes SE2-1 and SE2-2 illustrated in FIG. 10 may also have a mesh shape that is similar to the configuration illustrated in FIG. 11.

Rhombus-shaped openings T-OP may be defined by the first and second branches BP1 and BP2. Light emission areas LA of the pixels PX may be disposed on the openings T-OP, respectively. Accordingly, the first and second branches BP1 and BP2 may overlap the non-light emission area NLA. For example, the (1-2)-th sensing electrode SE1-2 and the second pen sensing electrode P-SE2 may overlap the non-light emission area NLA.

Because the first and second branches BP1 and BP2 are disposed in the non-light emission area NLA, light generated by the light emitting elements OLED of the pixels PX may be normally output without being influenced by the (1-2)-th sensing electrode SE1-2 and the second pen sensing electrode P-SE2.

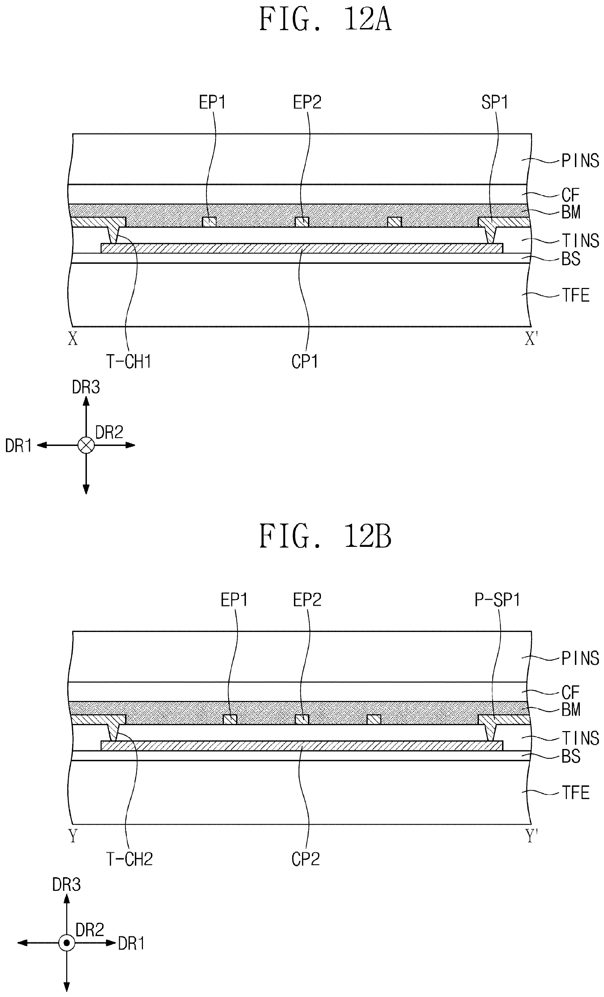

FIG. 12A is a cross-sectional view, taken along line X-X' illustrated in FIG. 10. FIG. 12B is a cross-sectional view taken along line Y-Y' illustrated in FIG. 10.

Referring to FIGS. 12A and 12B, the base layer BS may be disposed on the thin film encapsulation layer TFE, and a first connection pattern CP1 and a second connection pattern CP2 may be disposed on the base layer BS. The first connection pattern CP1 and the second connection pattern CP2 may be simultaneously patterned through the same process, and may be formed on the same layer. The first connection pattern CP1 and the second connection pattern CP2 may be formed by the above-described first conductive pattern CTL1 that is the same electrode.

The insulation layer TINS may be disposed on the base layer BS and may cover the first and second connection patterns CP1 and CP2. The first sensors SP1, the first pen sensors P-SP1, and the first and second extension patterns EP1 and EP2 may be disposed on the insulation layer TINS. The second sensors SP2 integrally formed with the first extension patterns EP1 and the second pen sensors P-SP2 integrally formed with the second extension pattern EP2 may also be disposed on the insulation layer TINS.

The first and second sensors SP1 and SP2, the first and second pen sensors P-SP1 and P-SP2, and the first and second extension patterns EP1 and EP2 may be simultaneously patterned through the same process to be formed on the same layer. The first and second sensors SP1 and SP2, the first and second pen sensors P-SP1 and P-SP2, and the first and second extension patterns EP1 and EP2 may be formed by the above-described second conductive pattern CTL2 that is the same electrode.

The first sensors SP1 may be connected to the first connection pattern CP1 through first contact holes T-CH1 defined in the insulation layer TINS. The first pen sensors P-SP1 may be connected to the second connection pattern CP2 through second contact holes T-CH2 defined in the insulation layer TINS.

A black matrix BM may be disposed on the insulation layer TINS and may cover the first sensors SP1, the first pen sensors P-SP1, and the first and second extension patterns EP1 and EP2. A color filter CF may be disposed on the black matrix BM, and a planarization insulation layer PINS may be disposed on the color filter CF.

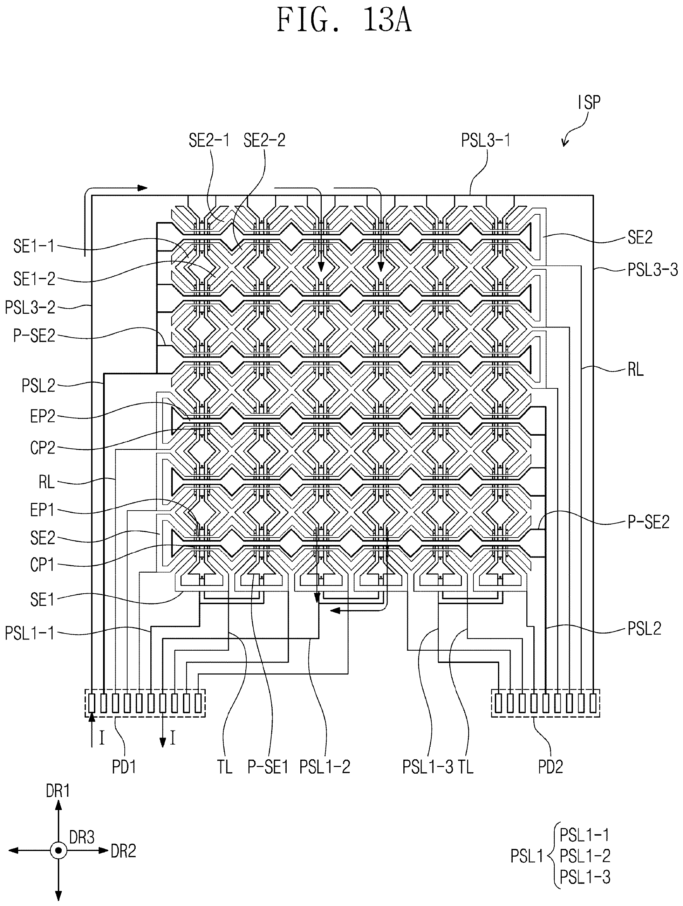

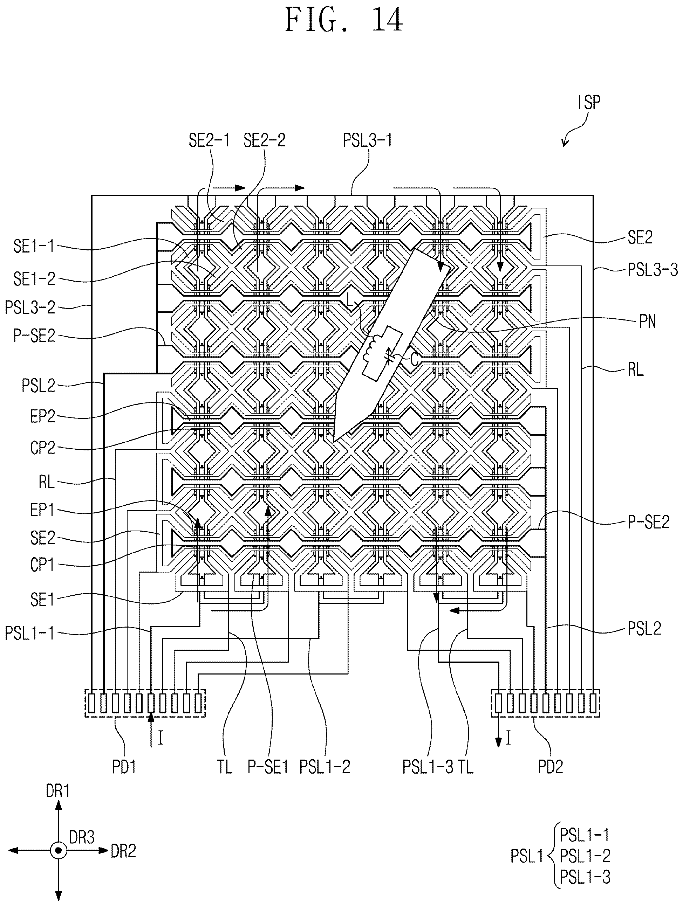

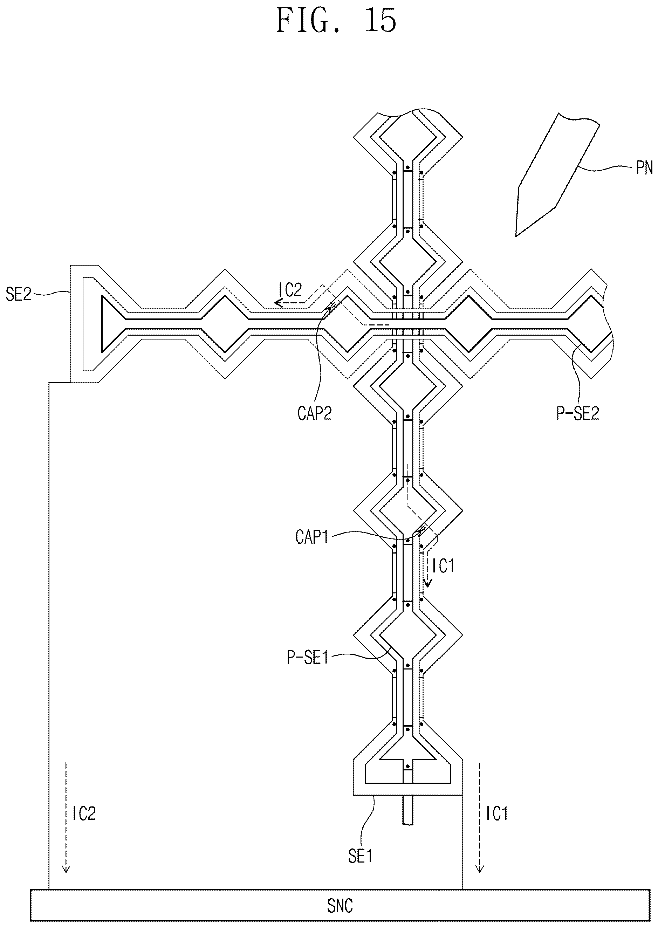

FIGS. 13A to 13C are views illustrating driving of pen sensing electrodes illustrated in FIG. 9. FIG. 14 is a view illustrating a charging operation of a pen that is disposed on an input sensor. FIG. 15 is a view illustrating a sensing operation for a touch of a pen illustrated in FIG. 14.

By way of example, in FIGS. 13A to 13C, and 14, peripheries of the active area AA and the inactive area NAA of the input sensor ISP are omitted. Hereinafter, in FIGS. 13A to 13C, and 14, the first pen sensing lines PSL1 are divided into (1-1)-th, (1-2)-th, and (1-3)-th pen sensing lines PSL1-1, PSL1-2, and PSL1-3 in the order from left to right.

Referring to FIG. 13A, the above-described second sensing section may include a charging section, and a pen sensing section that follows the charging section. During the charging section, the (1-1)-th, (1-2)-th, and (1-3)-th pen sensing lines PSL1-1, PSL1-2, and PSL1-3, the first pen sensing electrodes P-SE1, and the (3-1)-th, (3-2)-th, and (3-3)-th pen sensing lines PSL3-1, PSL3-2, and PSL3-3 may be driven to sequentially form a coil.

The first and second pads PD1 and PD2 may be connected to a driving circuit of the sensing IC. The driving circuit may apply a driving signal to the (1-1)-th, (1-2)-th, and (1-3)-th pen sensing lines PSL1-1, PSL1-2, and PSL1-3, the first pen sensing electrodes P-SE1, and the (3-1)-th, (3-2)-th, and (3-3)-th pen sensing lines PSL3-1, PSL3-2, and PSL3-3 in a specific order.

In the first section of the charging section, the driving circuit may be connected to the first pad PD1, to which the (3-2)-th pen sensing line PSL3-2 is connected, and the first pad PD1, to which the (1-2)-th pen sensing line PSL1-2 is connected. The driving circuit may apply a driving current "I" to the (3-2)-th pen sensing line PSL3-2. The driving current "I" may flow through the (3-2)-th pen sensing line PSL3-2, the first pen sensing electrodes P-SE1 connected to the (1-2)-th pen sensing line PSL1-2, and the (1-2)-th pen sensing line PSL1-2.

Accordingly, the (3-2)-th pen sensing line PSL3-2, the first pen sensing electrodes P-SE1 connected to the (1-2)-th pen sensing line PSL1-2, and the (1-2)-th pen sensing line PSL1-2 form a coil, and the driving current "I" may flow through the (3-2)-th pen sensing line PSL3-2, the first pen sensing electrodes P-SE1 connected to the (1-2)-th pen sensing line PSL1-2, and the (1-2)-th pen sensing line PSL1-2.

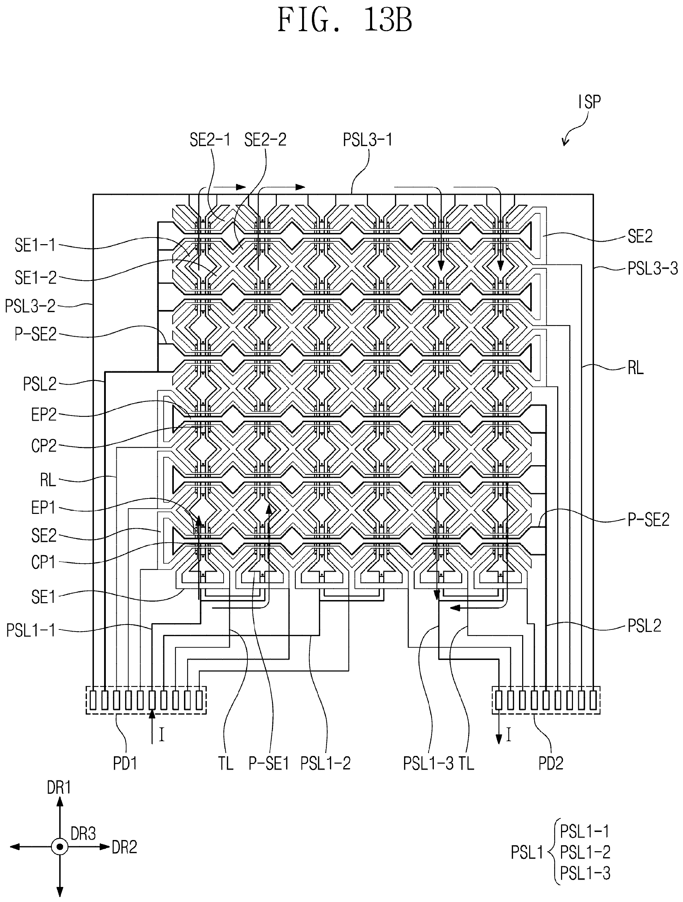

Referring to FIG. 13B, in a second section that follows the first section of the charging section, the driving circuit may be connected to the first pad PD1, to which the (1-1)-th pen sensing line PSL1-1 is connected, and the second pad PD2, to which the (1-3)-th pen sensing line PSL1-3 is connected. The driving circuit may apply a driving current "I" to the (1-1)-th pen sensing line PSL1-1. The driving current "I" may flow through the (1-1)-th pen sensing line PSL1-1, the first pen sensing electrodes P-SE1 connected to the (1-1)-th pen sensing line PSL1-1, the first pen sensing electrodes P-SE1 connected to the (1-3)-th pen sensing line PSL1-3, and the (1-3)-th pen sensing line PSL1-3.

Accordingly, the (1-1)-th pen sensing line PSL1-1, the first pen sensing electrodes P-SE1 connected to the (1-1)-th pen sensing line PSL1-1, the first pen sensing electrodes P-SE1 connected to the (1-3)-th pen sensing line PSL1-3, and the (1-3)-th pen sensing line PSL1-3 form a coil form, and the driving current "I" may flow through the (1-1)-th pen sensing line PSL1-1, the first pen sensing electrodes P-SE1 connected to the (1-1)-th pen sensing line PSL1-1, the first pen sensing electrodes P-SE1 connected to the (1-3)-th pen sensing line PSL1-3, and the (1-3)-th pen sensing line PSL1-3.

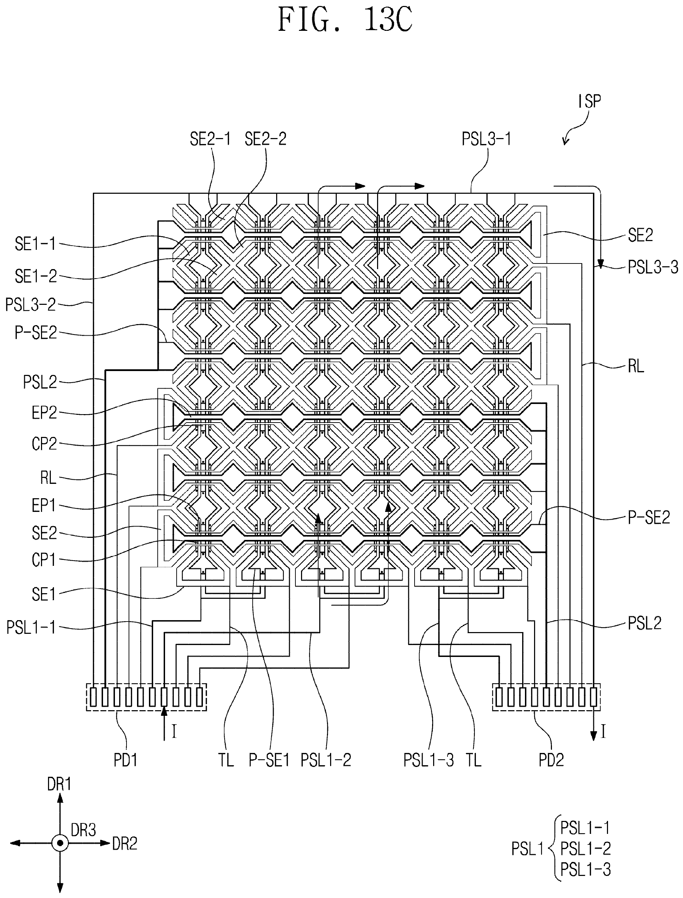

Referring to FIG. 13C, in a third section that follows the second section of the charging section, the driving circuit may be connected to the first pad PD1, to which the (1-2)-th pen sensing line PSL1-2 is connected, and the second pad PD2, to which the (3-3)-th pen sensing line PSL3-3 is connected. The driving circuit may apply a driving current "I" to the (1-2)-th pen sensing line PSL1-2. The driving current "I" may flow through the (1-2)-th pen sensing line PSL1-2, the first pen sensing electrodes P-SE1 connected to the (1-2)-th pen sensing line PSL1-2, and the (3-3)-th pen sensing line PSL3-3.

Accordingly, the (1-2)-th pen sensing line PSL1-2, the first pen sensing electrodes P-SE1 connected to the (1-2)-th pen sensing line PSL1-2, and the (3-3)-th pen sensing line PSL3-3 form a coil form, and the driving current "I" may flow through the (1-2)-th pen sensing line PSL1-2, the first pen sensing electrodes P-SE1 connected to the (1-2)-th pen sensing line PSL1-2, and the (3-3)-th pen sensing line PSL3-3.

Referring to FIG. 14, as described in FIGS. 13A to 13C, the driving current I may flow through the (1-1)-th, (1-2)-th, and (1-3)-th pen sensing lines PSL1-1, PSL1-2, and PSL1-3, and (3-1)-th pen sensing electrodes P-SE1, and (3-1)-th, (3-2)-th, and (3-3)-th pen sensing lines PSL3-1, PSL302, and PSL3-3, and the pen PN may be disposed on the input sensor ISP.

The pen PN may include an inductor "L" and a capacitor "C" that is connected to the inductor "L". The capacitor "C" may be a variable capacitor having a variable capacity. The LC resonance circuit may be formed by the inductor "L" and the capacitor "C". The pen PN may be disposed on the display module DM, and the capacitor "C" may be charged during the charging section.

The way of example, the pen PN may be disposed between the first pen sensing electrodes P-SE1 connected to the (1-1)-th pen sensing line PSL1-1 and the first pen sensing electrodes P-SE1 connected to the (1-3)-th pen sensing line PSL1-3.

In this case, a magnetic flux may be generated by the driving current "I" that flows through the (1-1)-th pen sensing line PSL1-1, the first pen sensing electrodes P-SE1 connected to the (1-1)-th pen sensing line PSL1-1, the first pen sensing electrodes P-SE1 connected to the (1-3)-th pen sensing line PSL1-3, and the (1-3)-th pen sensing line PSL1-3. The magnetic flux may flow into a ferrite core that surrounds a coil of the inductor "L", and then, an induced current may be generated in the coil of the inductor "L". Electric charges may be charged in the capacitor "C" by the induced current.

During the charging section, a constant voltage may be applied to the second pen sensing electrodes P-SE2 through the second pen sensing lines PSL2.

Hereinafter, for convenience of description, one first pen sensing electrode P-SE1 and one second pen sensing electrode P-SE2, through which an induced current generated by the pen PN flows, are illustrated in FIG. 15 by way of example. Furthermore, the first sensing electrode SE1 that is adjacent to the first pen sensing electrode P-SE1 and the second sensing electrode SE2 that is adjacent to the second pen sensing electrode P-SE2 are illustrated together with the first pen sensing electrode P-SE1 and the second pen sensing electrode P-SE2.

Referring to FIG. 15, the sensing circuit SNC of the sensing IC may be connected to the first and second sensing electrodes SE1 and SE2 during the pen sensing section that follows the charging section. During the pen sensing section, the driving current "I" might not be applied to the (1-1)-th, (1-2)-th, and (1-3)-th pen sensing lines PSL1-1, PSL1-2, and PLS1-3, the first pen sensing electrodes P-SE1, and the (3-1)-th, (3-2)-th, and (3-3)-th pen sensing lines PSL3-1, PSL3-2, and PSL3-3.

An LC resonance circuit of the pen PN may generate a magnetic flux while consuming charged electric charges. An induced current may be generated in the first pen sensing electrode P-SE1 and the second pen sensing electrode P-SE2 due to the magnetic flux.

A first induced current IC1 generated in the first pen sensing electrode P-SE1 may be provided to the first sensing electrode SE1 by the first sensing electrode SE1 and a first capacitor CAP1 formed by the first pen sensing electrode P-SE1, and may be provided to the sensing circuit SNC. A second induced current IC2 generated in the second pen sensing electrode P-SE2 may be provided to the second sensing electrode SE2 by a second capacitor CAP2 formed by the second sensing electrode SE2, and may be provided to the sensing circuit SNC.

The sensing circuit SNC may sense a position of the pen PN by sensing a first induced current IC1 and a second induced current IC2 provided through the first and second sensing electrodes SE1 and SE2. Accordingly, a touch of the pen PN may be sensed by the first and second pen sensing electrodes P-SE1 and P-SE2 and the first and second sensing electrodes SE1 and SE2.

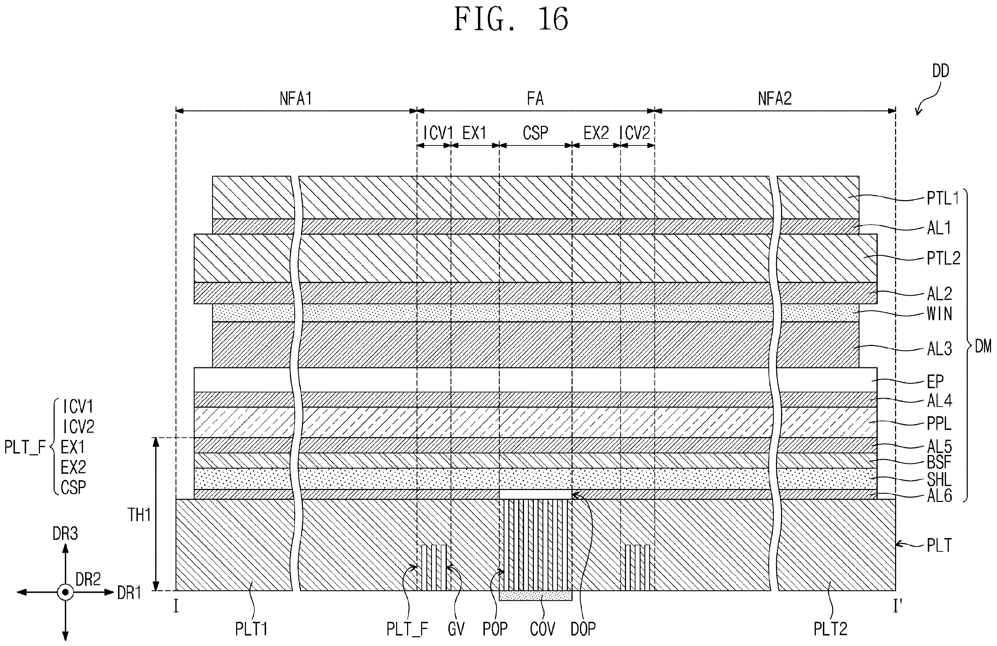

FIG. 16 is a cross-sectional view taken along line I-I' illustrated in FIG. 7.

By way of example, FIG. 16 illustrates an electronic panel EP including a display panel DP, and components disposed on and under the electronic panel EP.

Referring to FIG. 16, the display device DD may include a display module DM, a support plate PLT that is disposed under the display module DM to support the display module DM, and a cover layer COV that is disposed under the support plate PLT.

The display module DM may be a flexible display module. The display module DM may include a first non-folding area NFA1, a folding area FA, and a second non-folding area NFA2. As the folding area FA is folded about the folding axis FX described above, the display module DM may be folded.

The display module DM may include an electronic panel EP, a window WIN, a first protection layer PTL1, a second protection layer PTL2, a panel protection layer PPL, a base film BSF, an electromagnetic shield layer SHL, and first to sixth adhesive layers AL1 to AL6. The window WIN, the first protection layer PTL1, and the second protection layer PTL2 may be disposed on the electronic panel EP, and the panel protection layer PPL and the base film BSF may be disposed under the electronic panel EP. The electronic panel EP may include the display panel DP and the input sensor ISP as shown in FIG. 5.

The window WIN may be disposed on the electronic panel EP. The window WIN may protect the electronic panel EP from external scratches. The window WIN may have optically transparent properties. The window WIN may include glass. However, the present invention is not necessarily limited thereto, and the window WIN may include a synthetic resin film.

The window WIN may have a multi-layered structure or a single-layered structure. For example, the window WIN may include a plurality of synthetic resin films that are bonded to each other with an adhesive, or may include a glass substrate that are bonded to each other with an adhesive and a synthetic resin film.

The second protection layer PTL2 may be disposed on the window WIN, and the first protection layer PTL1 may be disposed on the second protection layer PTL2. Accordingly, the second protection layer PTL2 may be disposed between the first protection layer PTL1 and the window WIN. The first protection layer PTL1 and the second protection layer PTL2 may protect the window WIN and the electronic panel EP. Furthermore, the first protection layer PTL1 and the second protection layer PTL2 may increase resistance to impact of the display device DD.

The first protection layer PTL1 may include a flexible film including a plastic material, such as polyethylene terephthalate, and a hard coating layer that is coated on an upper surface of the flexible film. A flexible film of the first protection layer PTL1 may include various plastic materials, in addition to polyethylene terephthalate.

The second protection layer PTL2 may include a flexible film including a plastic material, such as polyethylene terephthalate, a hard coating layer that is coated on the upper surface of the flexible film, and a dummy film that is disposed to contact the lower surface of the flexible film. A flexible film of the second protection layer PTL2 may include various plastic materials, in addition to polyethylene terephthalate. A dummy film of the second protection layer PTL2 may include thermoplastic polyurethane or rubber, but the present invention is not necessarily limited thereto, and may include various materials having elasticity.

The panel protection layer PPL may be disposed under the electronic panel EP. The panel protection layer PPL may be disposed under the display panel DP illustrated in FIG. 5 to protect a lower portion of the display panel DP. The panel protection layer PPL may include a flexible plastic material, such as polyethylene terephthalate, but the present invention is not necessarily limited thereto, and may include various plastic materials.

The base film BSF may be disposed under the panel protection layer PPL. Accordingly, the base film BSF and the panel protection layer PPL may be disposed under the display panel DP illustrated in FIG. 5. The base film BSF may include a flexible plastic material, such as polyimide, but the present invention is not necessarily limited thereto, and may include various plastic materials.

An electromagnetic shield layer SHL may be disposed under the base film BSF. The electromagnetic shield layer SHL may include a metal. Specifically, the electromagnetic shield layer SHL may include magnetic metal powder. The electromagnetic shield layer SHL may shield electromagnetic waves that may be applied to the input sensor ISP under the display device DD. The electromagnetic shield layer SHL may directly contact a lower surface of the base film BSF.

The base film BSF may have a function of a support film for disposing the electromagnetic shield layer SHL. The electromagnetic shield layer SHL may include a resin, and a magnetic metal powder that is disposed in the resin. The resin having fluidity may be directly provided and cured on one surface of the base film BSF to form an electromagnetic shield layer SHL. The base film BSF may have an elastic modulus (e.g., Young's modulus) within a range of 2 GPa to 10 GPa, inclusive, at room temperature (e.g., 25° C).

One surface of the base film BSF may face a top, and an electromagnetic shield layer SHL may be formed on one surface of the base film. Thereafter, one surface of the base film BSF and the electromagnetic shield layer SHL are disposed to face a lower side, so that one surface of the base film BSF may define a lower surface of the base film BSF.

The base film BSF may provide a flat upper surface. The electromagnetic shield layer SHL may have a rough surface due to particles of the magnetic metal powder. The electromagnetic shield layer SHL may be disposed on a lower surface of the base film BSF, and an upper surface of the base film BSF may have a flat surface. Accordingly, due to the flat upper surface of the flat base film BSF, the flatness of the components on the base film BSF may be maintained.

The first adhesive layer AL1 may be disposed between the first protection layer PTL1 and the second protection layer PTL2. The first protection layer PTL1 and the second protection layer PTL2 may be combined with each other by the first adhesive layer AL1.

The second adhesive layer AL2 may be disposed between the second protection layer PTL2 and the window WIN. The second protection layer PTL2 and the window WIN may be combined with each other by the second adhesive layer AL2.

The third adhesive layer AL3 may be disposed between the window WIN and the electronic panel EP. The window WIN and the electronic panel EP may be combined with each other by the third adhesive layer AL3.

The fourth adhesive layer AL4 may be disposed between the electronic panel EP and the panel protection layer PPL. The electronic panel EP and the panel protection layer PPL may be combined with each other by the fourth adhesive layer AL4.

The fifth adhesive layer AL5 may be disposed between the panel protection layer PPL and the base film BSF. The panel protection layer PPL and the base film BSF may be combined with each other by the fifth adhesive layer AL5.

The support plate PLT may be disposed under the electromagnetic shield layer SHL, and the sixth adhesive layer AL6 may be disposed between the electromagnetic shield layer SHL and the support plate PLT. The electromagnetic shield layer SHL and the support plate PLT may be combined with each other by the sixth adhesive layer AL6. Accordingly, the display module DM may be combined with the support plate PLT by the sixth adhesive layer AL6.

The first to sixth adhesive layers AL1 to AL6 may include a transparent adhesive, such as a pressure-sensitive adhesive or an optical transparent adhesive, but the type of adhesive is not necessarily limited thereto.

The first protection layer PTL1 and the first adhesive layer AL1 may have the same width, and a periphery of the first protection layer PTL1 and a periphery of the first adhesive layer AL1 may overlap each other. In the third direction DR3, the first protection layer PTL1 may have a thickness that is greater than that of the first adhesive layer AL1. By way of example, in the third direction DR3, the first protection layer PTL1 may have a thickness of 70 µm, and the first adhesive layer AL1 may have a thickness of 25 µm. When ranges are provided herein, these ranges especially include the boundary values, even if they are not explicitly defined as "inclusive".

The second protection layer PTL2 and the second adhesive layer AL2 may have the same width, and the periphery of the second protection layer PTL2 and the periphery of the second adhesive layer AL2 may overlap each other. The second protection layer PTL2 and the second adhesive layer AL2 may have widths that are greater than those of the first protection layer PTL1 and the first adhesive layer AL1. A periphery of the second protection layer PTL2 and a periphery of the second adhesive layer AL2 may be disposed outside a periphery of the first protection layer PTL1 and a periphery of the first adhesive layer AL1.

In the third direction DR3, the second protection layer PTL2 may have a thickness that is greater than that of the second adhesive layer AL2. By way of example, in the third direction DR3, the second protection layer PTL2 may have a thickness of 79 µm, and the second adhesive layer AL2 may have a thickness of 35 µm.

The window WIN and the third adhesive layer AL3 may have the same width, and a periphery of the window WIN and a periphery of the third adhesive layer AL3 may overlap each other. The window WIN and the third adhesive layer AL3 may have widths that are smaller than those of the second protection layer PTL2 and the second adhesive layer AL2. A periphery of the window WIN and a periphery of the third adhesive layer AL3 may be disposed inside a periphery of the second protection layer PTL2 and a periphery of the second adhesive layer AL2.

In the third direction DR3, the window WIN may have a thickness that is less than that of the third adhesive layer AL3. By way of example, in the third direction DR3, the window WIN may have a thickness of 30 µm, and the third adhesive layer AL3 may have a thickness of 75 µm.

The electronic panel EP, the panel protection layer PPL, the base film BSF, the electromagnetic shield layer SHL, and the fourth and fifth adhesive layers AL4 and AL5 may have the same width. The electronic panel EP, the panel protection layer PPL, the base film BSF, the electromagnetic shield layer SHL, and the peripheries of the fourth and fifth adhesive layers AL4 and AL5 may overlap each other. The peripheries of the electronic panel EP, the panel protection layer PPL, the base film BSF, the electromagnetic shield layer SHL, and the fourth and fifth adhesive layers AL4 and AL5 may be disposed outside the peripheries of the window WIN and the third adhesive layer AL3.

By way of example, in the third direction DR3, the electronic panel EP may have a thickness within a range of 35 µm to 45 µm, inclusive. Preferably, in the third direction DR3, the electronic panel EP may have a thickness of 40 µm.

In the third direction DR3, the panel protection layer PPL may have a thickness that is greater than that of the electronic panel EP. In the third direction DR3, the panel protection layer PPL may have a thickness of 50 µm.

In the third direction DR3, the base film BSF may have a thickness that is smaller than that of the panel protection layer PPL. By way of example, in the third direction DR3, the base film BSF may have a thickness of 5 µm to 50 µm. Preferably, in the third direction DR3, the base film BSF may have a thickness of 25 µm.

In the third direction DR3, the electromagnetic shield layer SHL may have a thickness that is smaller than that of the panel protection layer PPL. By way of example, in the third direction DR3, the electromagnetic shield layer SHL may have a thickness of 25 µm to 36 µm. Preferably, in the third direction DR3, the electromagnetic shield layer SHL may have a thickness of 36 µm.

By way of example, in the third direction DR3, each of the fourth adhesive layer AL4 and the fifth adhesive layer AL5 may have a thickness of 25 µm, and the sixth adhesive layer AL6 may have a thickness of 16 µm.

In the sixth adhesive layer AL6, dummy opening DOP that overlaps the folding area FA may be defined. Opposite peripheries of the sixth adhesive layer AL6 may overlap the periphery of the electronic panel EP.

Openings POP may be defined in the support plate PLT that is disposed under the electromagnetic shield layer SHL. No openings POP may be defined in the electromagnetic shield layer SHL. As used herein, the term, "imperforate" describes a structure that is without any openings, perforations, or holes and so the electromagnetic shield layer SHL may be imperforate. The openings POP may be defined while passing through a portion of the support plate PLT in the third direction DR3. In a plan view, the openings POP may overlap the folding area FA. Grooves GV may be defined on a lower surface of the support plate PLT. In a plan view, the grooves GV may overlap the folding area FA.

The support plate PLT may include metal. For example, the support plate PLT may include stainless steel. By way of example, in the third direction DR3, the support plate PLT may have a thickness in a range of 80 µm to 150 µm, inclusive.

The support plate PLT including metal may shield electromagnetic waves that may be applied to the input sensor ISP under the display device DD. In an embodiment of the present invention, the electromagnetic waves may be more efficiently shielded by shielding electromagnetic waves that may be applied to the input sensor ISP together with the electromagnetic shield layer SHL and the support plate PLT.

The support plate PLT may include a first support plate PLT1, a second support plate PLT2, and a folding part PLT_F. By way of example, boundaries of the first support plate PLT1, the second support plate PLT2, and the folding part PLT_F are illustrated by a dotted line in the support plate PLT.

The folding part PLT_F may be disposed between the first support plate PLT1 and the second support plate PLT2. The first support plate PLT1, the folding part PLT_F, and the second support plate PLT2 may be arranged in the first direction DR1. The openings POP may be defined in the folding part PLT_F. The grooves GV may be defined on a lower surface of the folding part PLT_F.

The first support plate PLT1 may be disposed under the first non-folding area NFA1, and may overlap the first non-folding area NFA1 in a plan view. The second support plate PLT2 may be disposed under the second non-folding area NFA2, and may overlap the second non-folding area NFA2 in a plan view. The folding part PLT_F may be disposed under the folding area FA, and may overlap the folding area FA in a plan view.

The folding part PLT_F may include a curved portion CSP, a first extension EX1, a second extension EX2, a first inverse curvature portion ICV1, and a second inverse curvature portion ICV2. By way of example, the curved portion CSP, the first extension EX1, the second extension EX2, the first inverse curvature portion ICV1, and the second inverse curvature portion ICV2 are illustrated by a dotted line on the support plate PLT, and the reference numerals are illustrated on the display module DM by extending the boundary dotted line upward for convenience.

The curved portion CSP, the first extension EX1, the second extension EX2, the first inverse curvature portion ICV1, and the second inverse curvature portion ICV2 may be arranged in the first direction DR1. By way of example, the curved part CSP may be disposed at the center of the folding part PLT_F.

The curved portion CSP may be disposed between the first inverse curvature portion ICV1 and the second inverse curvature portion ICV2. The first extension EX1 may be disposed between the curved portion CSP and the first inverse curvature portion ICV1. The second extension EX2 may be disposed between the curved portion CSP and the second inverse curvature portion ICV2. The curved portion CSP may be disposed between the first extension EX1 and the second inverse curvature portion ICV2.

The first inverse curvature portion ICV1 may be disposed between the first support plate PLT1 and the first extension EX1. The second inverse curvature portion ICV2 may be disposed between the second support plate PLT2 and the second extension EX2.

The openings POP may be defined in the curved portion CSP. The grooves GV may be defined in lower surfaces of the first and second inverse curvature portions ICV1 and ICV2.

The dummy opening DOP defined in the sixth adhesive layer AL6 may overlap the curved portion CSP. For example, the sixth adhesive layer AL6 may be opened in an area that overlaps the curved portion CSP.

The cover layer COV may be disposed under the support plate PLT. The cover layer COV may cover the openings POP defined in the support plate PLT. The cover layer COV may be disposed under the curved portion CSP, and may contact a lower surface of the curved portion CSP and covers the openings POP.

The cover layer COV may have a lower modulus of elasticity (e.g., Young's modulus) than that of the support plate PLT. For example, the cover layer COV may include thermoplastic polyurethane or rubber, but the material of the cover layer COV is not necessarily limited thereto. The cover layer COV may be manufactured in a sheet form to be attached to the support plate PLT. In the third direction DR3, the cover layer COV may have a thickness of 16 µm.

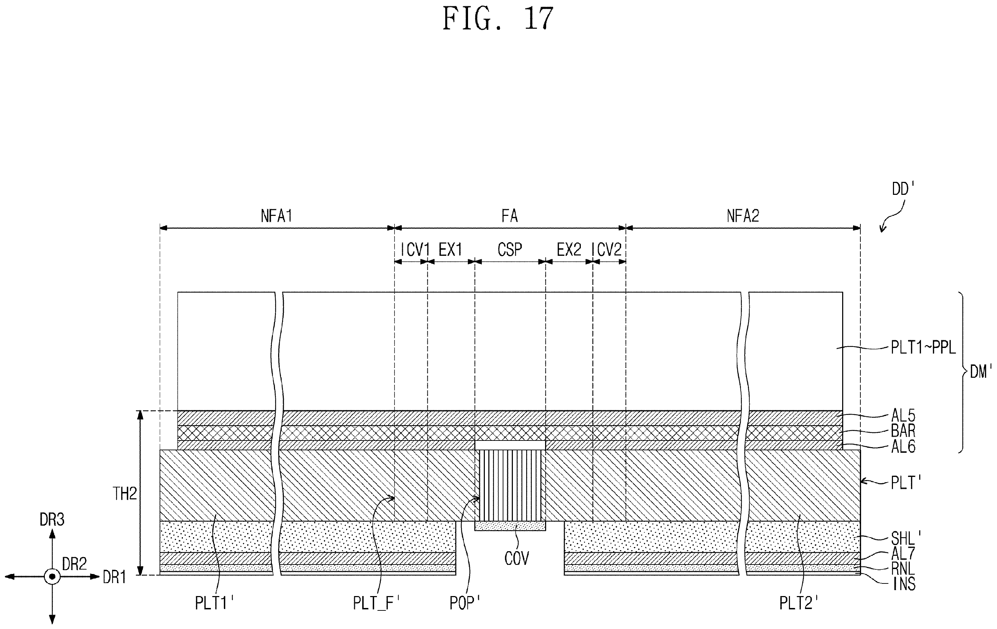

FIG. 17 is a view illustrating a configuration of a comparative display device according to a comparative embodiment.

By way of example, FIG. 17 is illustrated as a cross section corresponding to FIG. 16, and the first protection layer PTL1 to the panel protection layer PPL are illustrated as a single layer. Hereinafter, the configurations illustrated in FIG. 17 will be described, focusing on configurations that are different from those illustrated in FIG. 16. To the extent that an element is not described in detail with respect to this figure, it may be understood that the element is at least similar to a corresponding element that has been described elsewhere within the present invention.

Referring to FIG. 17, the display module DM' of the comparative display device DD' may include a barrier layer BAR. The barrier layer BAR may be disposed under the fifth adhesive layer AL5, and the sixth adhesive layer AL6 may be disposed under the barrier layer BAR. The barrier layer BAR may include a flexible plastic material, such as polyimide or polyethylene terephthalate.

The comparative display device DD' may include a support plate PLT' that is disposed under the sixth adhesive layer AL6. The support plate PLT' may include a non-metallic material. For example, the support plate PLT' may include a reinforced fiber composite. The reinforced fiber composite may include a carbon fiber reinforced plastic or a glass fiber reinforced plastic. In the support plate PLT', openings POP' that overlap the curved portion CSP may be defined, but the above-described grooves GV might not be defined in the support plate PLT'.

The comparative display device DD' may include an electromagnetic shield layer SHL', a seventh adhesive layer AL7, a heat dissipation layer RHL, and an insulation layer INS that are disposed under the support plate PLT'. The electromagnetic shield layer SHL' may be disposed under the support plate PLT'. The seventh adhesive layer AL7 may be disposed under the electromagnetic shield layer SHL', and the heat dissipation layer RHL may be disposed under the seventh adhesive layer. The heat dissipation layer RHL may include copper. The insulation layer INS may be disposed under the heat dissipation layer RHL. The electromagnetic shield layer SHL', the seventh adhesive layer AL7, the heat dissipation layer RHL, and the insulation layer INS may be opened and separated in an area that overlaps the curved portion CSP.

Because the support plate PLT' contains a non-metallic material, the electromagnetic shield layer SHL' and the heat dissipation layer RHL may be used to shield the electromagnetic waves applied to the input sensor ISP. The heat dissipation layer RHL may perform electromagnetic shielding and heat dissipation functions. The insulation layer INS may cover a lower surface of the heat dissipation layer RHL to prevent corrosion of the heat dissipation layer RHL.

Referring to FIGS. 16 and 17, in the display device DD, layers from the fifth adhesive layer AL5 to the support plate PLT may have a first thickness TH1. In the comparative display device DD', layers from the fifth adhesive layer AL5 to the insulation layer INS may have a second thickness TH2. The second thickness TH2 may be greater than the first thickness TH1.

When the support plate PLT' contains a non-metallic material, the electromagnetic shield layer SHL', the heat dissipation layer RHL, a seventh adhesive layer AL7 for combining the electromagnetic shield layer SHL' and the heat dissipation layer RHL, and an insulation layer INS for insulating the heat dissipation layer RHL may be additionally used. Accordingly, a thickness of the comparative display device DD' may be greater than a thickness of the display device DD'.

However, in an embodiment of the present invention, the thickness of the display device DD may be reduced because the electromagnetic shield layer SHL is disposed on the support plate PLT and the support plate PLT contains a metal that may shield electromagnetic waves.

Table 1 below is a view illustrating anti-impact performance simulation results for the comparative display device and the display device as a table.

**[Table 1]**

| Test item | Comparative display device | Display device |
|---|---|---|
| Front surface pressed | 1.0 | 0.95 |
| Falling of panel during unfolding | 1.0 | 0.75 |
| Falling of panel during folding | 1.0 | 0.89 |
| Pressing of fingernail | 1.0 | 0.94 |

In Table 1, the front surface pressing may be defined as a test that is conducted by pressing a block having a specific weight on the comparative display device DD' and the display device DD toward the comparative display device DD' and the display device DD.

In Table 1, the falling of the panel during unfolding may be defined as a test that is performed by dropping the comparative display device DD' and the display device DD at a specific height while the comparative display device DD' and the display device DD are unfolded. In Table 1, the falling of the panel during folding may be defined as a test that is performed by dropping the comparative display device DD' and the display device DD at a specific height while the comparative display device DD' and the display device DD are folded.

In Table 1, the pressing of the fingernail may be defined as a test that is performed by pressing an artificial structure of a nail shape toward the comparative display device DD' and the display device DD.

Test conditions for the comparative display device DD' and the display device DD are the same, and when the stress of the comparative display device DD' is 1, the relative stress of the display device DD is illustrated in Table 1 as a numerical value. As the stress increases, the anti-impact performance may decrease and a possibility of damage may increase.

Referring to Table 1, the stress of the display device DD is lower than that of the comparative display device DD' in the pressing of a front surface, the falling of the panel during unfolding, the falling of the panel during folding, and the pressing of a fingernail. Accordingly, the anti- impact performance of the display device DD may be greater than that of the comparative display device DD'. As a result, the possibility of damage to the display device DD may be lower than that of the comparative display device DD' against an external impact.

Although the thickness of the display device DD is smaller than that of the comparative display device DD', the anti-impact performance of the display device DD including the support plate PLT having metal may be further enhanced than the comparative display device DD'.

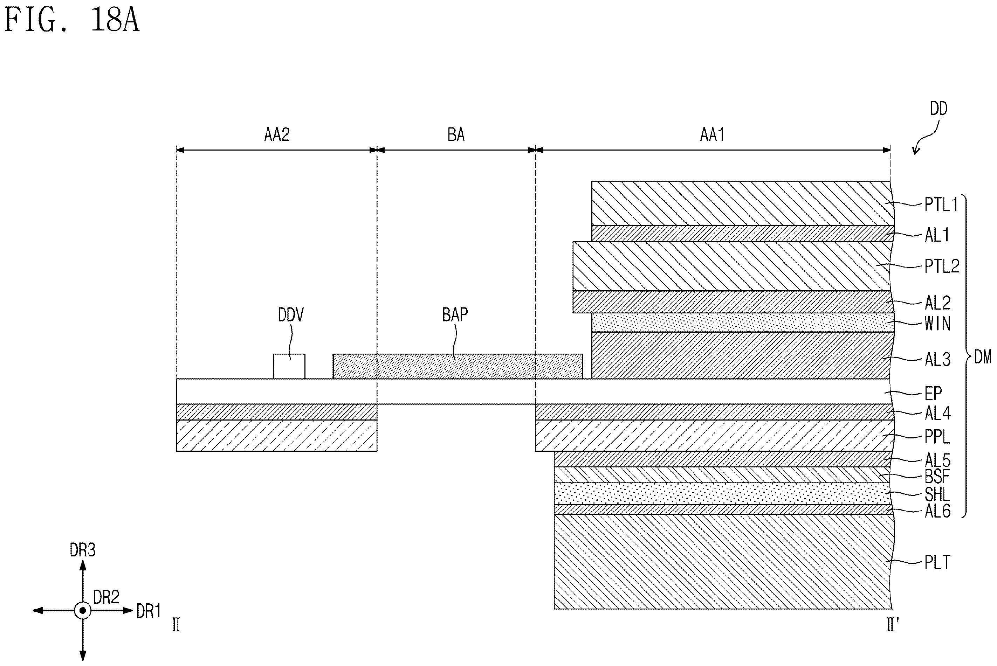

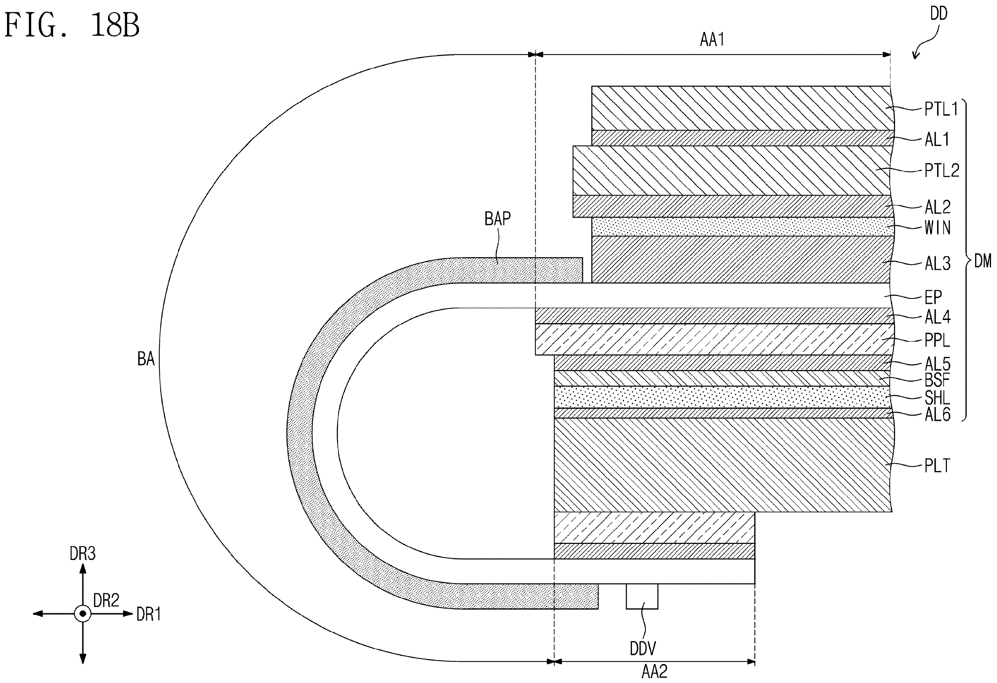

FIG. 18A is a cross-sectional view taken along line II-II' illustrated in FIG. 7. FIG. 18B is a view illustrating a state, in which a bending area illustrated in FIG. 18A is bent.

Referring to FIG. 18A, the panel protection layer PPL and the fourth adhesive layer AL4 might not be disposed under the bending area BA. The panel protection layer PPL and the fourth adhesive layer AL4 may be disposed under the second area AA2 of the electronic panel EP. The data driver DDV may be disposed on the second area AA2 of the electronic panel EP.

The display device DD may further include a bending protection layer BAP. The bending protection layer BAP may be disposed on the bending area BA, a portion of the first area AA1, which is adjacent to the bending area BA, and a portion of the second area AA2, which is adjacent to the bending area BA. The bending protection layer BAP may extend continuously from a portion of the first area AA1, which is adjacent to the bending area BA, to the bending area BA and a portion of the second area AA2, which is adjacent to the bending area BA.

The bending protection layer BAP may be spaced apart from the third adhesive layer AL3. The bending protection layer BAP may be spaced apart from the data driver DDV in the second area AA2. The bending protection layer BAP may include an acrylic resin or a urethane resin.

Referring to FIG. 18B, the bending area BA may be bent to a predetermined curvature. The bending area BA may be bent so that the second area AA2 may be disposed under the first area AA1. Accordingly, the data driver DDV may be disposed under the first area AA1.

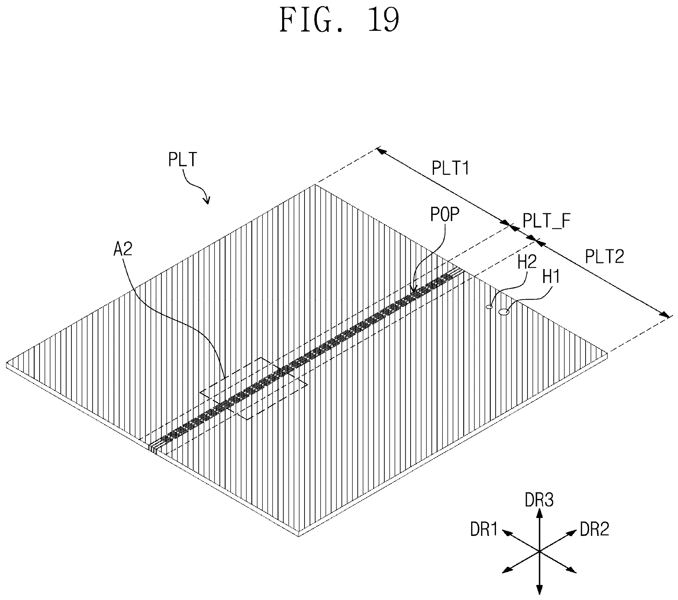

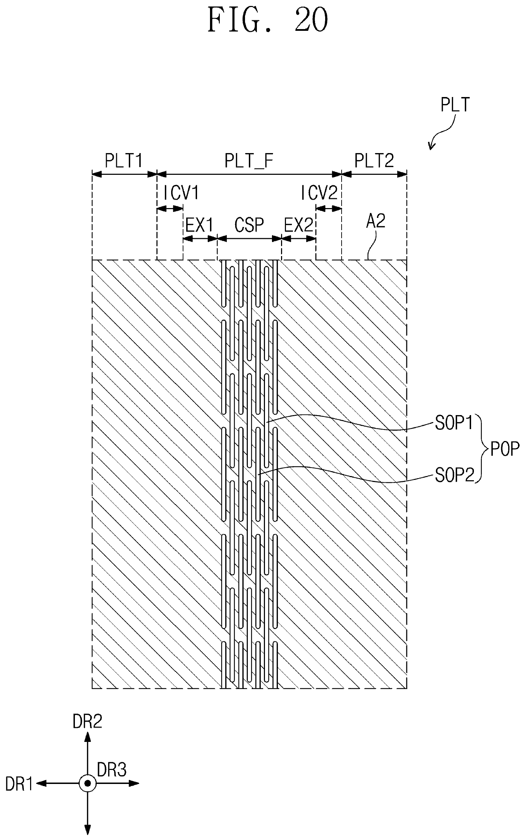

FIG. 19 is a perspective view of a support plate illustrated in FIG. 16. FIG. 20 is an enlarged view of a plane of a second area A2 illustrated in FIG. 11.

Referring to FIGS. 19 and 20, the support plate PLT may include a first support plate PLT1, a folding part PLT_F, and a second support plate PLT2 arranged in the first direction DR1. The folding part PLT_F may include a first inverse curvature portion ICV1, a first extension EX1, a curved portion CSP, a second extension EX2, and a second inverse curvature portion ICV2 that are arranged in the first direction DR1.

A grid pattern may be defined in the curved portion CSP. For example, the openings POP defined in the curved portion CSP may be arranged in a specific rule. The openings POP may be arranged in a grid shape to form a grid pattern of the curved portion CSP.

A first hole H1 and a second hole H2 may be defined in the second support plate PLT2. The first hole H1 and the second hole H2 may be adjacent to a periphery of the second support plate PLT2. The camera CA and the sensor SN described above may be disposed in the first hole H1 and the second hole H2, respectively.

The openings POP may extend longer in the second direction DR2 than in the first direction DR1. The openings POP may include a plurality of first sub-openings SOP1 that are arranged in the second direction DR2, and a plurality of second sub-openings SOP2 that are arranged in the second direction DR2 adjacent to the first sub-openings SOP1 in the first direction DR1. The first sub-openings SOP1 may be staggered with respect to the second sub-openings SOP2 so as not to be in a same line.

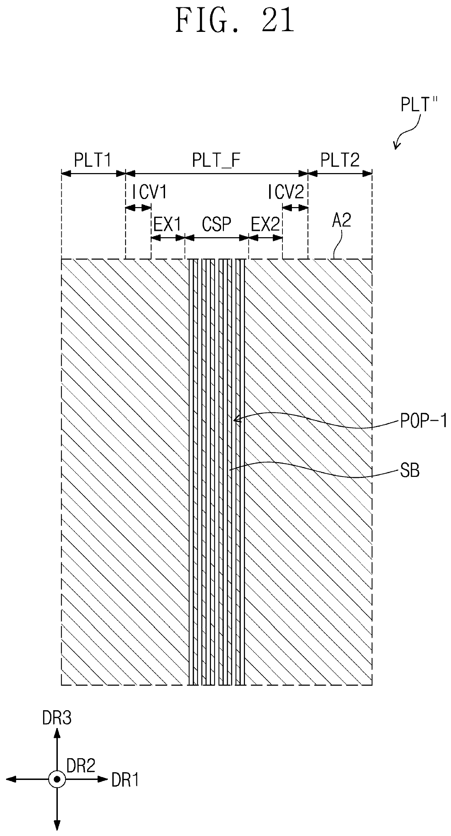

FIG. 21 is a view illustrating a configuration of a support plate according to an embodiment of the present invention.

By way of example, FIG. 21 is a plan view corresponding to FIG. 20.

Referring to FIG. 21, an opening POP-1 defined in a support plate PLT" may extend in the second direction DR2, and may be arranged in the first direction DR1. The shape may be defined in the form of a stripe. Portions of the curved portion CSP, which are disposed between the opening POP-1, may be defined as support bars SB.

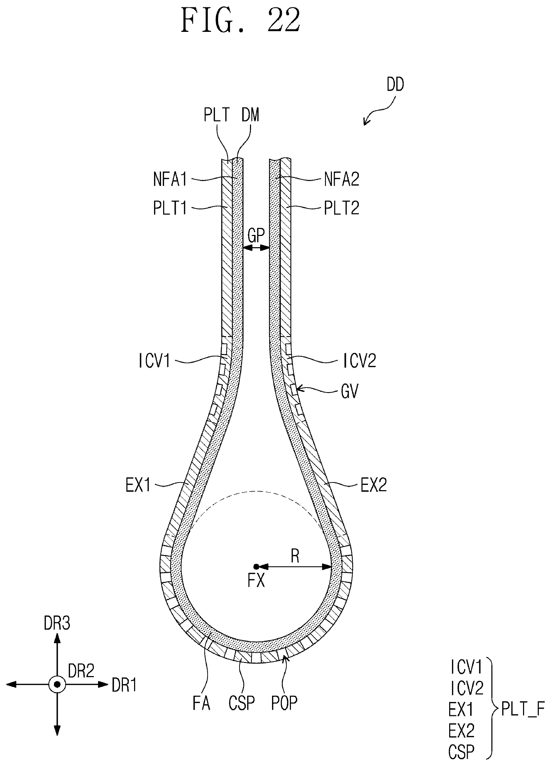

FIG. 22 is a view illustrating a folding state of a display device illustrated in FIG. 16.

By way of example, in FIG. 22, the display module DM is illustrated as a single layer, and the cover layer COV is omitted. By way of example, the boundaries of the first and second support plates PLT1 and PLT2, the curved portion CSP, the first and second extensions EX1 and EX2, and the first and second inverse curved portions ICV1 and ICV2 are illustrated by a dotted line on the support plate PLT.

Referring to FIG. 22, the support plate PLT may be folded about a folding axis FX. The support plate PLT may be folded in a dumbbell shape, for example, a shape of a straight line segment that ends in a rounded section. As the support plate PLT is folded, the display module DM may be folded together with the support plate PLT.

The folding part PLT_F may be folded about the folding axis FX so that the support plate PLT may be folded. When the folding part PLT_F is folded, the curved portion CSP may be bent to have a predetermined curvature. As the openings POP are defined at the curved portion CSP, the flexibility of the curved portion CSP may be increased. Accordingly, the curved portion CSP may be more easily bent by the openings POP. The folding area FA of the display module DM on the curved portion CSP may be bent to have a radius of curvature "R".

When the folding part PLT_F is folded, the first inverse curvature portion ICV1 may be bent opposite to the curved portion CSP. Furthermore, when the folding part PLT_F is folded, the second inverse curvature portion ICV2 may be bent opposite to the curved portion CSP. The second inverse curvature portion ICV2 may have a shape that is symmetrical to the first inverse curvature portion ICV1.

As the grooves GV are defined in a lower surface of each of the first and second inverse curvature portions ICV1 and ICV2, the flexibility of the first and second inverse curvature portions ICV1 and ICV2 may be increased. Accordingly, the first and second inverse curvature portions ICV1 and ICV2 may be more easily bent due to the grooves GV.

When the folding part PLT_F is folded, the first support plate PLT1 and the second support plate PLT2 may be maintained in a flat state. Accordingly, the first and second non-folding areas NFA1 and NFA2 may be maintained in a flat state due to the first and second support plates PLT1 and PLT2.

When the folding part PLT_F is folded, an interval GP between the first non-folding area NFA1 and the second non-folding area NFA2 in the first direction DR1 may be smaller than a diameter of a circle having a radius of curvature "R". According to the configuration, the support plate PLT may be folded in a dumbbell shape.

The first extension EX1 may be maintained in an equilibrium state between the curved portion CSP and the first inverse curvature portion ICV1. The first extension EX1 may extend flat from the first inverse curvature portion ICV1 toward the curved portion CSP.

The second extension EX2 may be maintained in a flat state between the curved portion CSP and the second inverse curvature portion ICV2. The second extension EX2 may extend flat from the second inverse curvature portion ICV2 toward the curved portion CSP.

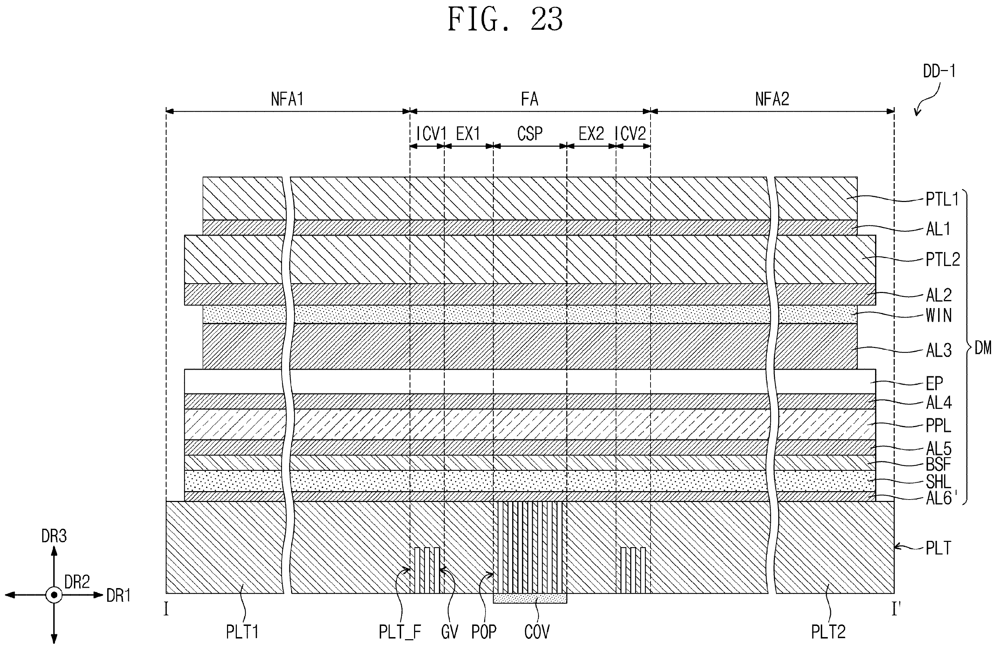

FIGS. 23 to 33 are views illustrating configurations of display devices according to various embodiments of the present invention.

By way of example, FIGS. 23 to 33 are illustrated in a cross section corresponding to FIG. 16, and hereinafter, configurations illustrated in FIGS. 23 to 33 will be described, focusing on configurations that are different from those illustrated in FIG. 16. Furthermore, the same configurations as those illustrated in FIG. 16 are illustrated by using the same reference numerals. To the extent that an element is not described in detail with respect to this figure, it may be understood that the element is at least similar to a corresponding element that has been described elsewhere within the present invention.

Referring to FIG. 23, in the display device DD-1, a dummy opening DOP might not be defined in the sixth adhesive layer AL6' unlike the above-described sixth adhesive layer AL6. The sixth adhesive layer AL6' may be disposed on the upper surface of the curved portion CSP and covers the openings POP.

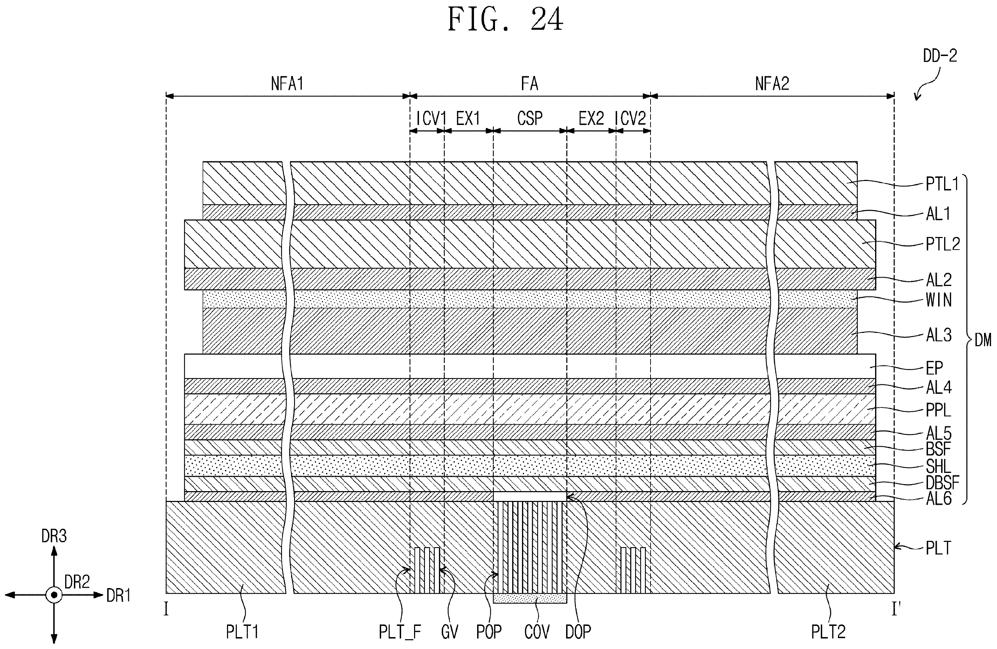

Referring to FIG. 24, a display device DD-2 may further include a dummy base film DBSF that is disposed between the electromagnetic shield layer SHL and the adhesive layer AL6. The dummy base film DBSF may include the same material as that of the base film BSF, and may have the same thickness as that of the base film BSF.

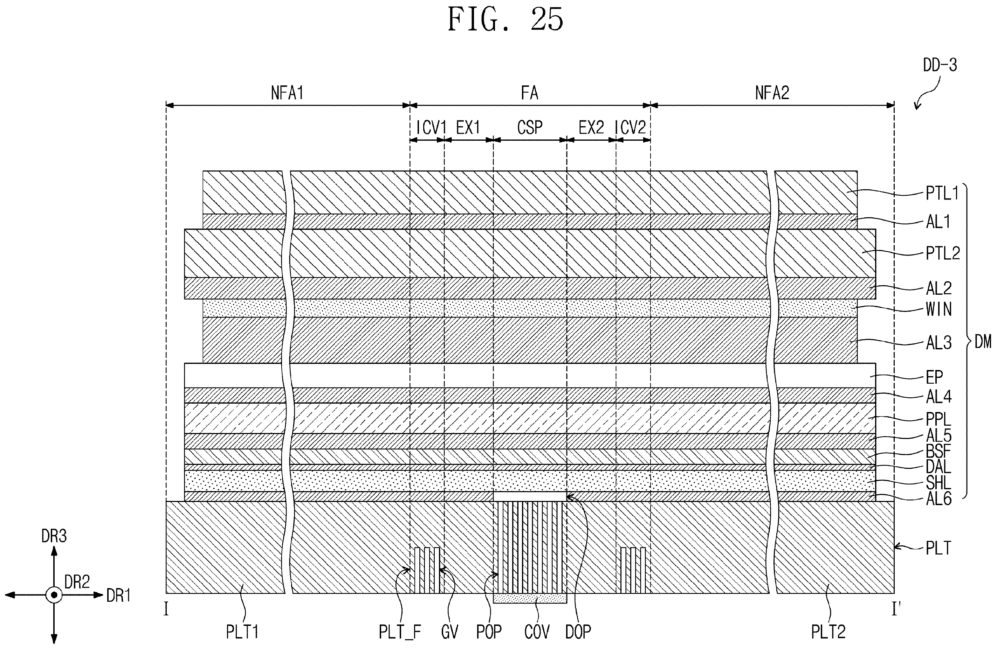

Referring to FIG. 25, a display device DD-3 may further include a dummy adhesive layer DAL that is disposed between the electromagnetic shield layer SHL and the base film BSF. The electromagnetic shield layer SHL may be manufactured in a sheet form, and may be attached to the lower surface of the base film BSF by the dummy adhesive layer DAL.

A thickness of the dummy adhesive layer DAL in the third direction DR3 may be smaller than thicknesses of the electromagnetic shield layer SHL and the base film BSF. The dummy adhesive layer DAL may include a pressure-sensitive adhesive, but the present invention is not necessarily limited thereto, and may include various adhesives.

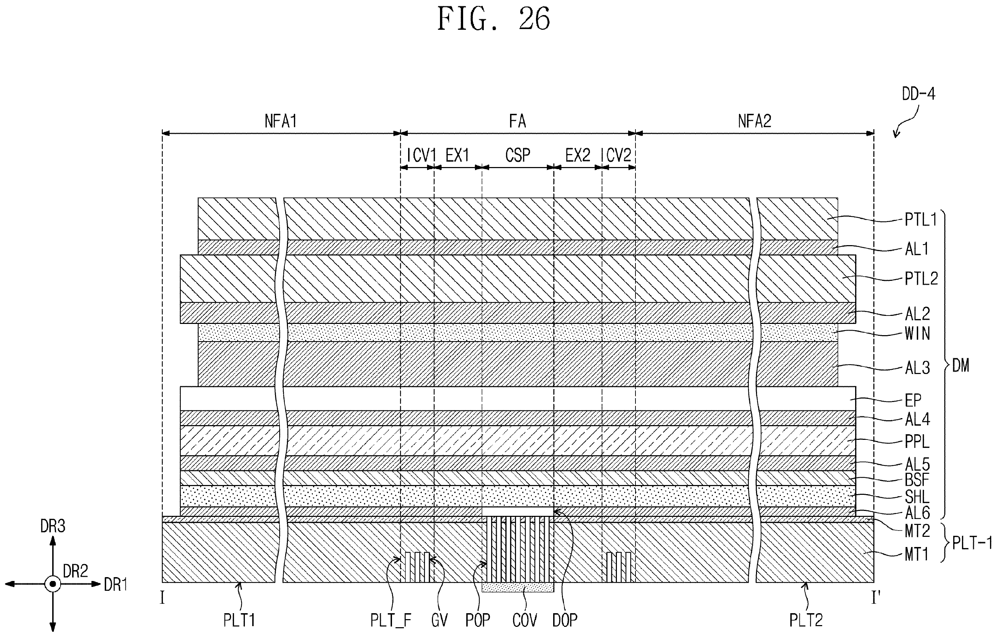

Referring to FIG. 26, a display device DD-4 may include a support plate PLT-1, and the support plate PLT-1 may include a first metal layer MT1 and a second metal layer MT2 that is disposed on the first metal layer MT1.

An electrical conductivity of the first metal layer MT1 may be different from that of the second metal layer MT2. For example, the electrical conductivity of the second metal layer MT2 may be greater than that of the first metal layer MT1. The first metal layer MT1 may have a rigidity that is higher than that of the second metal layer MT2.

In an embodiment of the present invention, the second metal layer MT2 may include copper, and the first metal layer MT1 may include stainless steel or a titanium alloy. Copper may have a higher electrical conductivity than stainless steel or a titanium alloy. Stainless steel or a titanium alloy may have a rigidity that is higher than that of copper. However, the present invention is not necessarily limited thereto, and the second metal layer MT2 may include various metals having high electrical conductivity, and the first metal layer MT1 may include various metals having a higher rigidity.

The second metal layer MT2 may directly contact an upper surface of the first metal layer MT1. For example, the second metal layer MT2 including copper may be formed directly on the upper surface of the first metal layer MT1 through a deposition process.

In metals having the same thickness, as the electrical conductivity increases, the electromagnetic shielding function may become greater. In an embodiment of the present invention, a thickness of the second metal layer MT2 having a higher electrical conductivity and a lower rigidity than those of the first metal layer MT1 may be smaller than a thickness of the first metal layer MT1. In an embodiment of the present invention, a thickness of the first metal layer MT1 having a lower electrical conductivity and a higher rigidity those that of the second metal layer MT2 may be greater than that of the second metal layer MT2.

The first metal layer MT1 has a weak electromagnetic shielding function, but has high rigidity, and thus, may have a good support function. The second metal layer MT2 has a high electromagnetic shielding function but has weak rigidity, and thus, may have a weak support function.

The second metal layer MT2 having the greater electromagnetic shielding function may supplement the low electromagnetic shielding function of the first metal layer MT1. Furthermore, the first metal layer MT1 having the greater rigidity may supplement the lower support function of the second metal layer MT2.

When the first metal layer MT1 includes stainless steel, the first metal layer MT1 may have an elastic modulus *(e.g., Young's modulus)* of 170 GPa to 210 GPa at room temperature (e.g., 25°C). Furthermore, in the third direction DR3, the first metal layer MT1 may have a thickness within the range of 80 µm to 120 µm, inclusive.

When the first metal layer MT1 includes a titanium alloy, the first metal layer MT1 may have an elastic modulus (e.g., Young's modulus) within a range of 100 GPa to 150 GPa, inclusive, at room temperature (e.g., 25°C). Furthermore, in the third direction DR3, the first metal layer MT1 may have a thickness within a range of 100 µm to 120 µm, inclusive.

When the second metal layer MT2 includes copper, the second metal layer MT2 may have a thickness in a range of 3 µm to 20 µm, inclusive, in the third direction DR3.

The openings POP may be defined in the first metal layer MT1 and the second metal layer MT2. The grooves GV may be defined on a lower surface of the first metal layer MT1, and might not be defined in the second metal layer MT2.

Table 2 below illustrates thicknesses of the support plate PLT of the display device DD and the support plate PLT-1 of the display device DD-4 set in various ways. Furthermore, Table 2 is a simulation result illustrating the thicknesses of the support plate PLT-1 having an electromagnetic shielding function, similar to that of the support plate PLT having a thickness of 150 µm. By way of example, copper (Cu) and stainless steel (SUS) were used as the support plate PLT-1.

**[Table 2]**

| | | DD (PLT) | CASE1 DD-4 (PLT-4) | CASE2 DD-4 (PLT-4) | CASE3 DD-4 (PLT-4) | CASE4 DD-4 (PLT-4) |
|---|---|---|---|---|---|---|
| Material | Cu | | 5 to 20 | 5 to 15 | 5 to 15 | 3 to 15 |
| | SUS | 150 | 80 | 90 | 100 | 120 |
| Total thickness | | 150 | 85 to 100 | 95 to 105 | 105 to 115 | 123 to 135 |

Even though the thicknesses of the support plates PLT-1 are set to 85 µm to 100 µm, 95 µm to 105 µm, 105 µm to 115 µm, and 123 µm to 135 µm, they may have an electromagnetic shielding function, similar to that of a support plate PLT with a thickness of 150 µm.

As described above, the display device DD may have a thickness that is smaller than that of the comparative display device DD'. Furthermore, in an embodiment of the present invention, the support plate PLT-1 may have a thickness that is smaller than that of the support plate PLT while maintaining an electromagnetic shielding function, similar to that of the support plate PLT. Accordingly, the display device DD-4 may have a thickness that is smaller than that of the display device DD.

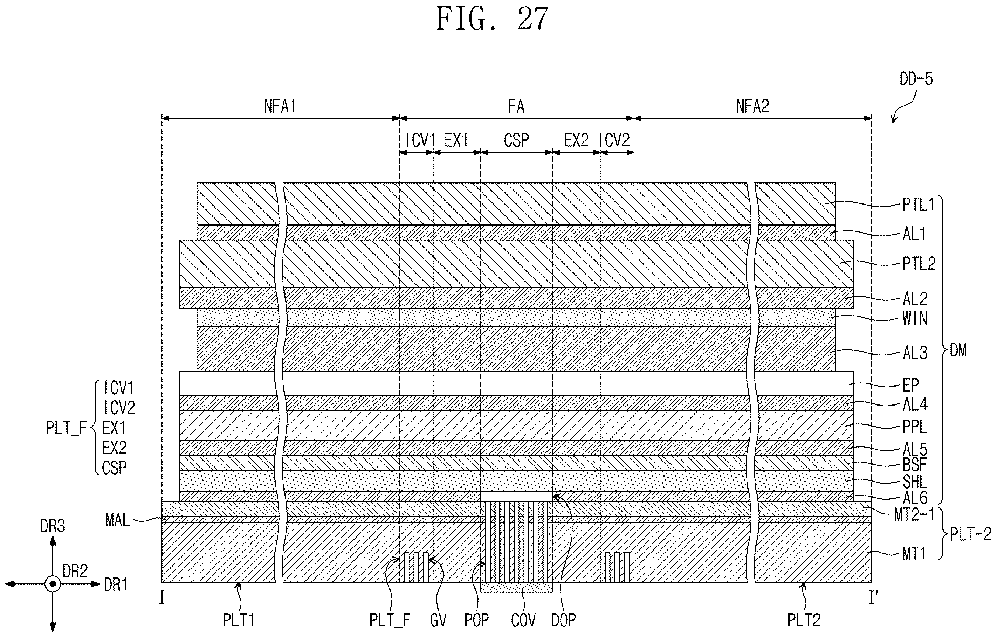

Referring to FIG. 27, a display device DD-5 may include a support plate PLT-2, and the support plate PLT-2 may include a first metal layer MT1, a second metal layer MT2-1 that is disposed on the first metal layer MT1, and a metal adhesive layer MAL that is disposed between the first metal layer MT1 and the second metal layer MT2-1. The first metal layer MT1 may have the same configuration as that of the first metal layer MT1 illustrated in FIG. 26.

The second metal layer MT2-1 may have a greater electrical conductivity than that of the first metal layer MT1. For example, the second metal layer MT2-1 may include aluminum. The first metal layer MT1 may have a rigidity that is higher than that of the second metal layer MT2-1.

The second metal layer MT2-1 might not directly contact an upper surface of the first metal layer MT1. For example, the second metal layer MT2-1 may be attached to the upper surface of the first metal layer MT1 through a metal adhesive layer MAL. The metal adhesive layer MAL may include a pressure-sensitive adhesive, but the present invention is not necessarily limited thereto, and may include various adhesives.

When the second metal layer MT2-1 includes aluminum, the second metal layer MT2-1 may have a thickness within a range of 25 µm to 50 µm, inclusive, in the third direction DR3. When the first metal layer MT1 includes stainless steel, the first metal layer MT1 may have a thickness within a range of 80 µm to 100 µm, inclusive.

The second metal layer MT2-1 may have an electrical conductivity that is smaller than that of the second metal layer MT2 illustrated in FIG. 26. In this case, the second metal layer MT2-1 may have a thickness that is greater than that of the second metal layer MT2 illustrated in FIG. 26.

Under a condition that the sum of the thicknesses of the first metal layer MT1 and the second metal layer MT2-1 is smaller than 150 µm, the numerical value of the first metal layer MT1 and the numerical value of the second metal layer MT2-1 may be variously set within the above range. For example, when the thickness of the second metal layer MT2-1 is 50 µm, the thickness of the first metal layer MT1 may be set to a value that is greater than or equal to 80 µm and less than 100 µm. Furthermore, when the thickness of the first metal layer MT1 is 100 µm, the thickness of the second metal layer MT2-1 may be set to a value that is greater than or equal to 25 µm and less than 50 µm.

The openings POP may be defined in a first metal layer MT1, a second metal layer MT2-1, and a metal adhesive layer MAL. The grooves GV may be defined in a lower surface of the first metal layer MT1, and might not be defined in the second metal layer MT2-1 and the metal adhesive layer MAL.

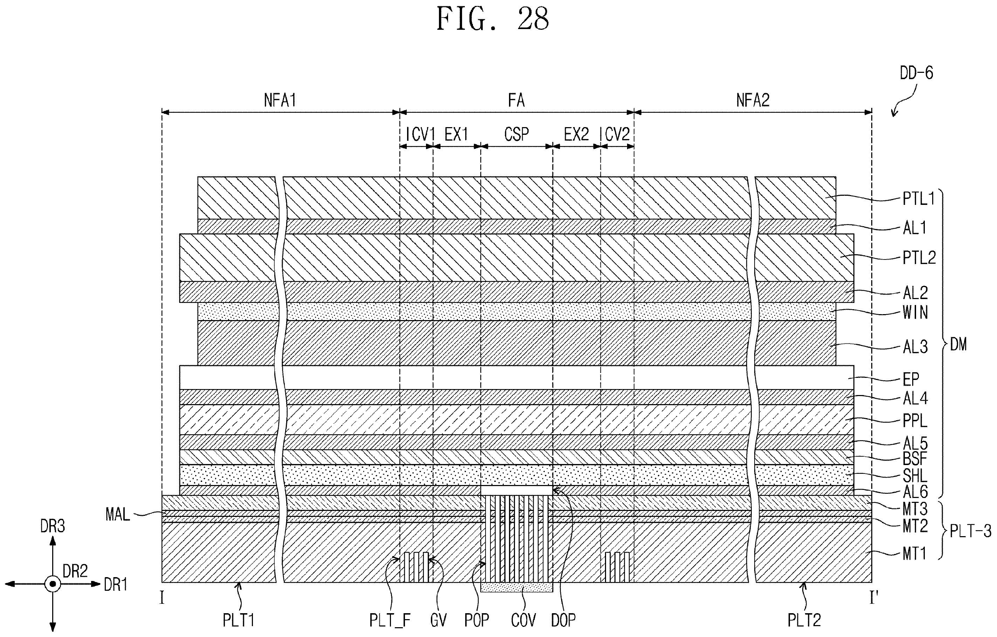

Referring to FIG. 28, a display device DD-6 may include a support plate PLT-3, and the support plate PLT-3 may include a first metal layer MT1, a second metal layer MT2 that is disposed on the first metal layer MT1, a third metal layer MT3 that is disposed on the second metal layer MT2, and a metal adhesive layer MAL that is disposed between the second metal layer MT2 and the third metal layer MT3.

The first metal layer MT1 and the second metal layer MT2 may have the same configurations as those of the first metal layer MT1 and the second metal layer MT2 illustrated in FIG. 26, respectively. The metal adhesive layer MAL may have the same configuration as that of the metal adhesive layer MAL illustrated in FIG. 27.

The third metal layer MT3 may have the same configuration as that of the second metal layer MT2-1 illustrated in FIG. 27. Accordingly, the third metal layer MT3 may be smaller than the first metal layer MT1, and may have a greater thickness than that of the second metal layer MT2. Furthermore, the third metal layer MT3 may have an electrical conductivity that is greater than that of the first metal layer MT1 and smaller than that of the second metal layer MT2.

The second metal layer MT2 may directly contact the upper surface of the first metal layer MT1, and the third metal layer MT3 may be attached to the upper surface of the second metal layer MT2 through the metal adhesive layer MAL.

The openings POP may be defined in a first metal layer MT1, a second metal layer MT2, a third metal layer MT3, and a metal adhesive layer MAL. The grooves GV may be defined in a lower surface of the first metal layer MT1, and might not be defined in the second metal layer MT2, the third metal layer MT3, and the metal adhesive layer MAL.

In the following drawings, the first metal layer MT1, the second metal layer MT2, the third metal layer MT3, and the metal adhesive layer MAL, that are indicated by the same reference numerals as before may have the same configurations as those of the first metal layer MT1, the second metal layer MT2, the third metal layer MT3, and the metal adhesive layer MAL described above.

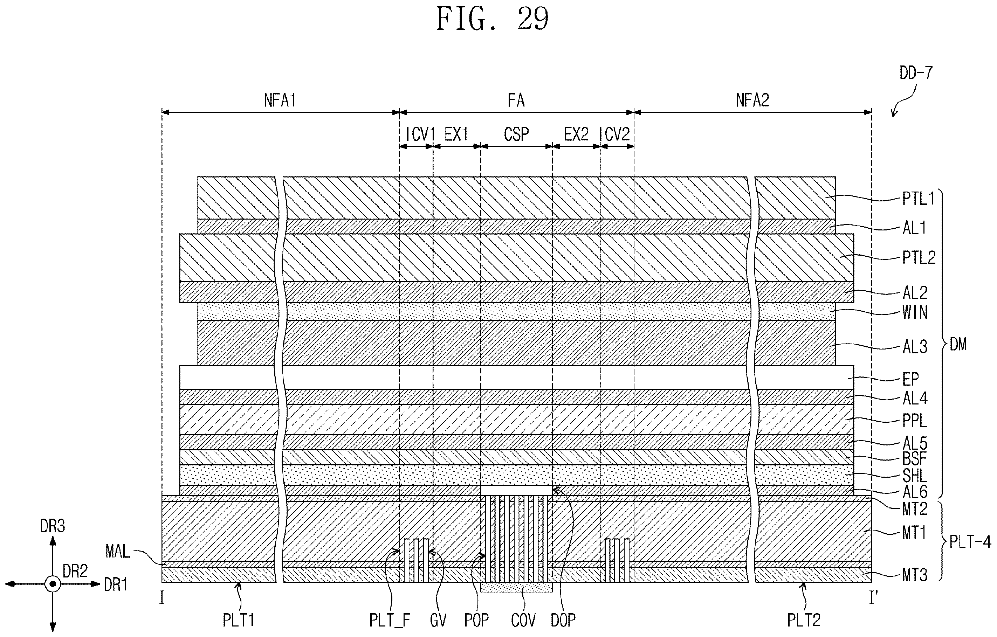

Referring to FIG. 29, the display device DD-7 may include a support plate PLT-4, and the support plate PLT-4 may include a first metal layer MT1, a second metal layer MT2 that is disposed on the first metal layer MT1, a third metal layer MT3 that is disposed under the first metal layer MT1, and a metal adhesive layer MAL that is disposed between the first metal layer MT1 and the third metal layer MT3.

The third metal layer MT3 may have a thickness that is smaller than that of the first metal layer MT1 and greater than that of the second metal layer MT2. The third metal layer MT3 may have an electrical conductivity that is higher than that of the first metal layer MT1 and lower than that of the second metal layer MT2. The third metal layer MT3 may be attached to the lower surface of the first metal layer MT1 through the metal adhesive layer MAL.

The openings POP may be defined in a first metal layer MT1, a second metal layer MT2, a third metal layer MT3, and a metal adhesive layer MAL. The grooves GV may be defined on a lower surface of the third metal layer MT3, and may extend to a lower portion of the first metal layer MT1 through the third metal layer MT3 and the metal adhesive layer MAL. The grooves GV might not be defined in the second metal layer MT2.

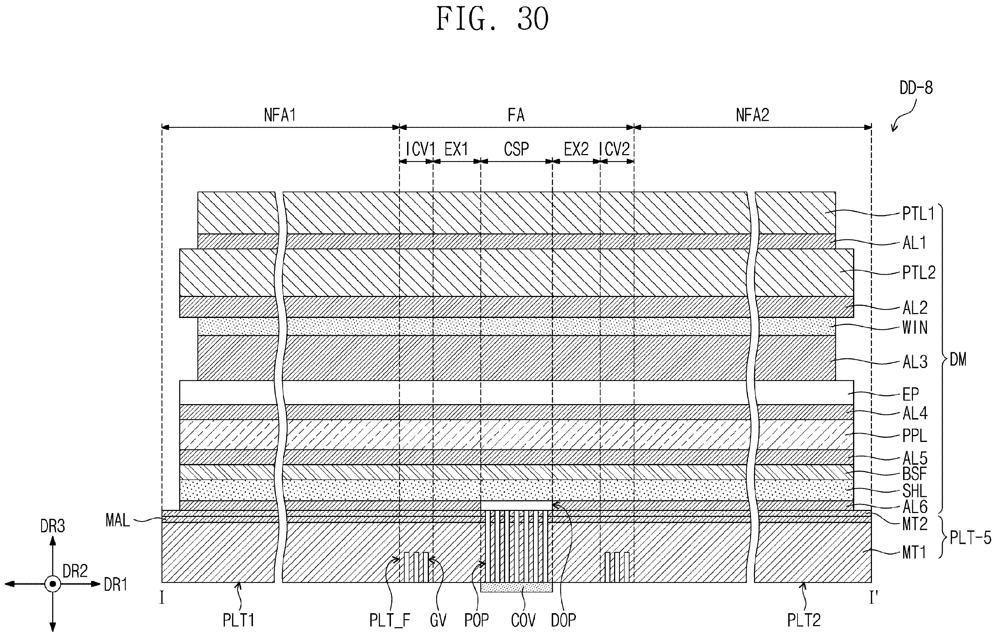

Referring to FIG. 30, the display device DD-8 may include a support plate PLT-5, and the support plate PLT-5 may include a first metal layer MT1, a second metal layer MT2 that is disposed on the first metal layer MT1, and a metal adhesive layer MAL that is disposed between the first metal layer MT1 and the second metal layer MT2.

The second metal layer MT2 may be manufactured in a sheet form, and may be disposed on the first metal layer MT1. In this case, the second metal layer MT2 may be attached to the upper surface of the first metal layer MT1 by a metal adhesive layer MAL disposed between the first metal layer MT1 and the second metal layer MT2.

The openings POP may be defined in a first metal layer MT1, a second metal layer MT2, and a metal adhesive layer MAL. The grooves GV may be defined in a lower surface of the first metal layer MT1, and might not be defined in the second metal layer MT2 and the metal adhesive layer MAL.

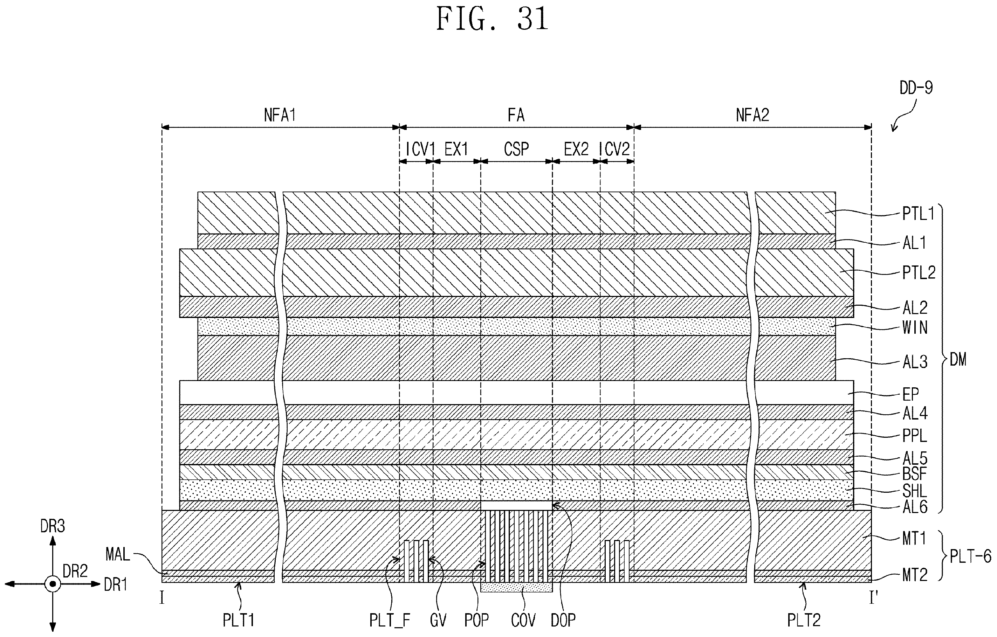

Referring to FIG. 31, the display device DD-9 may include a support plate PLT-6, and the support plate PLT-6 may include a first metal layer MT1, a second metal layer MT2 that is disposed under the first metal layer MT1, and a metal adhesive layer MAL that is disposed between the first metal layer MT1 and the second metal layer MT2. The second metal layer MT2 is manufactured in a sheet form, and may be attached to the lower surface of the first metal layer MT1 by the metal adhesive layer MAL.

To prevent corrosion of the second metal layer MT2, an insulation layer may be disposed on a lower surface of the second metal layer MT2.

The openings POP may be defined in a first metal layer MT1, a second metal layer MT2, and a metal adhesive layer MAL. The grooves GV may be defined on a lower surface of the second metal layer MT2, and may extend to a lower portion of the first metal layer MT1 through the second metal layer MT2 and the metal adhesive layer MAL.

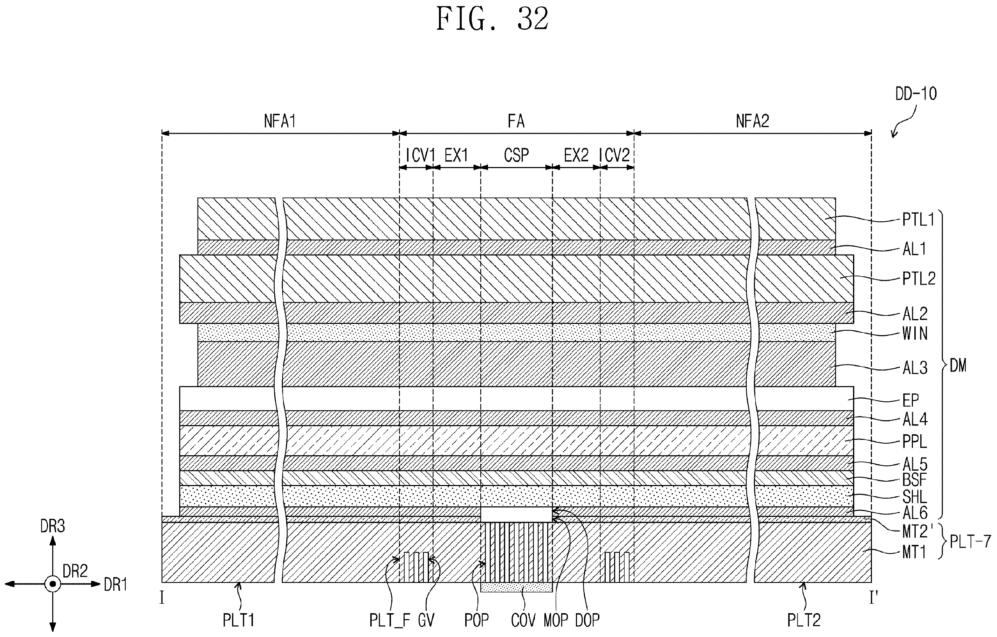

Referring to FIG. 32, a display device DD-10 may include a support plate PLT-7, and the support plate PLT-7 may include a first metal layer MT1 and a second metal layer MT2 that is disposed on the first metal layer MT1. The second metal layer MT2-1 may directly contact an upper surface of the first metal layer MT1. In the second metal layer MT2', a metal opening MOP that overlaps the folding area FA may be defined. The metal opening MOP may overlap the curved portion CSP.

The openings POP may be defined in the first metal layer MT1, and the grooves GV may be defined on the lower surface of the first metal layer MT1.

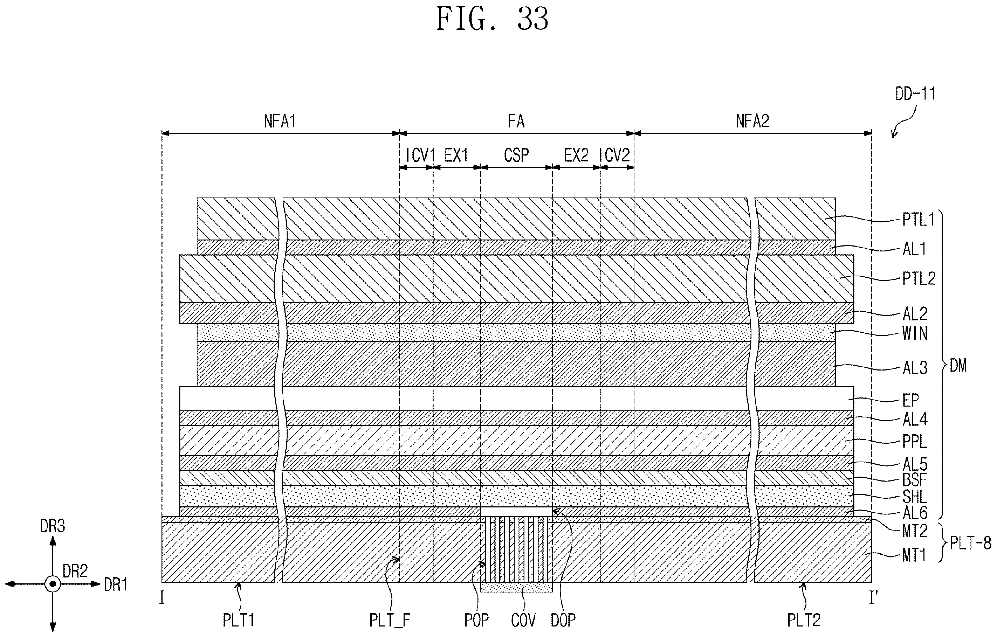

Referring to FIG. 33, a display device DD-11 may include a support plate PLT-8, and the support plate PLT-8 may include a first metal layer MT1 and a second metal layer MT2 that is disposed on the first metal layer MT1. The openings POP may be defined in the first metal layer MT1. The above-described grooves GV might not be defined in the first metal layer MT1.

In an embodiment of the present invention, because the input sensor senses a first input through a touch of a user and a second input through a pen, a separate digitizer is not used, so that the thickness of the display device may be reduced.

In addition, in an embodiment of the present invention, the electromagnetic shield layer may be disposed under the display panel, and the support plate including metal may be disposed under the electromagnetic shield layer. Accordingly, the electromagnetic shield layer and the support plate together shield electromagnetic waves that may be applied to the input sensor, so that the electromagnetic waves may be shielded more efficiently.

Although the present invention has been described with reference to the embodiments, it will be appreciated by an ordinary skilled in the art, to which the present invention pertains, that the present invention may be modified and changed within the scope of the appended claims. Therefore, the technical scope of the present invention should not necessarily be limited to the detailed description of the specification.

## Claims

1. A display device (DD), comprising:
a display panel (DP) including a folding area (FA);
an input sensor (ISP) disposed on the display panel (DP), and configured to sense a first input by a touch of a user and a second input by a pen (PN) or stylus;
a base film (BSF) disposed under the display panel (DP);
an electromagnetic shield layer (SHL) disposed under the base film (BSF);
a support plate (PLT) disposed under the electromagnetic shield layer (SHL), and in which openings (POP) overlapping the folding area (FA) are defined; and
an adhesive layer (AL6, AL6') disposed between the electromagnetic shield layer (SHL) and the support plate (PLT).

2. The display device (DD) of claim 1, wherein the electromagnetic shield layer (SHL) is imperforate.

3. The display device (DD) of claim 1 or 2, wherein the electromagnetic shield layer (SHL) includes a magnetic metal powder, and the base film (BSF) includes a plastic material.

4. The display device (DD) of at least one of claims 1 to 3, wherein the electromagnetic shield layer (SHL) directly contacts a lower surface of the base film (BSF).

5. The display device (DD) of at least one of claims 1 to 4, wherein the base film (BSF) has a thickness within a range of 5 µm to 50 µm, and has an elastic modulus within a range of 2 GPa to 10 GPa,
wherein the electromagnetic shield layer (SHL) has a thickness within a range of 25 µm to 36 µm, and
wherein the support plate (PLT) includes a stainless steel and has a thickness within a range of 80 µm to 150 µm.

6. The display device (DD) of at least one of claims 1 to 5, wherein the support plate (PLT) includes a folding part (PLT_F), in which the openings (POP) are defined,
wherein the folding part (PLT_F) includes:
a first inverse curvature portion (ICV1);
a second inverse curvature portion (ICV2); and
a curved portion (CSP) disposed between the first inverse curvature portion (ICV1) and the second inverse curvature portion (ICV2), and in which the openings (POP) are defined,
wherein grooves (GV) are defined on lower surfaces of the first inverse curvature portion (ICV1) and the second inverse curvature portion (ICV2), and
wherein when the folding part (PLT_F) is folded, the curved portion (CSP) is curved to a predetermined level of curvature, and the first inverse curvature portion (ICV1) and second inverse curvature portion (ICV2) are curved in an opposite direction to the curved portion (CSP).

7. The display device (DD) of claim 6, wherein a dummy opening (DOP) overlapping the curved portion (CSP) is defined in the adhesive layer (AL6).

8. The display device (DD) of claim 6, wherein the adhesive layer (AL6') is disposed on an upper surface of the curved portion (CSP) and covers the openings (POP).

9. The display device (DD) of at least one of claims 1 to 8, further comprising:
a dummy base film (DBSF) disposed between the electromagnetic shield layer (SHL) and the adhesive layer (AL6, AL6'),
wherein the dummy base film (DBSF) includes a same material as that of the base film (BSF).

10. The display device (DD) of at least one of claims 1 to 3 or 5 to 9, when not dependent on claim 4, further comprising:
a dummy adhesive layer (DAL) disposed between the electromagnetic shield layer (SHL) and the base film (BSF),
wherein a thickness of the dummy adhesive layer (DAL) is smaller than each of a thickness of each of the electromagnetic shield layer (SHL) and the base film (BSF).

11. The display device (DD) of at least one of claims 1 to 10, wherein the support plate (PLT) includes:
a first metal layer (MT1); and
a second metal layer (MT2) disposed on the first metal layer (MT1), and having an electrical conductivity that is higher than that of the first metal layer (MT1).

12. The display device (DD) of claim 11, wherein the second metal layer (MT2) directly contacts an upper surface of the first metal layer (MT1).

13. The display device (DD) of at least one of claims 11 or 12, wherein the second metal layer (MT2) has a thickness that is smaller than that of the first metal layer (MT1).

14. The display device (DD) of claim 13, wherein the first metal layer (MT1) includes a stainless steel, has an elastic modulus within a range of 170 GPa to 210 GPa and has a thickness within a range of 80 µm to 120 µm, and
wherein the second metal layer (MT2) includes copper and has a thickness within a range of 3 µm to 20 µm.

15. The display device (DD) of claim 13, wherein the first metal layer (MT1) includes a titanium alloy, has an elastic modulus within a range of 100 GPa to 150 GPa and has a thickness within a range of 100 µm to 120 µm, and wherein the second metal layer (MT2) includes aluminum, and has a thickness within a range of 25 µm to 50 µm.

16. The display device (DD) of at least one of claims 11 to 15, wherein the support plate (PLT) further includes a third metal layer (MT3) disposed on the second metal layer (MT2), and
wherein the third metal layer (MT3) has a thickness that is smaller than that of the first metal layer (MT1) and greater than that of the second metal layer (MT2) and has an electrical conductivity that is higher than that of the first metal layer (MT1) and lower than that of the second metal layer (MT2).

17. The display device (DD) of at least one of claims 11 to 15, wherein the support plate (PLT) further includes a third metal layer (MT3) disposed under the first metal layer (MT2), and
wherein the third metal layer (MT3) has a thickness that is smaller than that of the first metal layer (MT1) and greater than that of the second metal layer (MT2) and has an electrical conductivity that is higher than that of the first metal layer (MT1) and lower than that of the second metal layer (MT2).

18. The display device (DD) of at least one of claims 1 to 10, wherein the support plate (PLT) includes:
a first metal layer (MT1);
a second metal layer (MT2) disposed under the first metal layer (MT1), and having an electrical conductivity that is higher than that of the first metal layer (MT1); and
a metal adhesive layer (MAL) disposed between the first metal layer (MT1) and the second metal layer (MT2).

19. A display device (DD), comprising:
a display panel (DP) including a folding area (FA);
an input sensor (ISP) disposed on the display panel (DP), and configured to sense a first input by a touch of a user and a second input by a pen (PN) or stylus;
an electromagnetic shield layer (SHL) disposed under the display panel (DP); and
a support plate (PLT) disposed under the electromagnetic shield layer (SHL), and in which openings (POP) overlapping the folding area (FA) are defined,
wherein the support plate (PLT) includes:
a first metal layer (MT1); and
a second metal layer (MT2) disposed on the first metal layer (MT1), and having an electrical conductivity that is different from that of the first metal layer (MT1).

20. An electronic device (ED), comprising:
a display device (DD) according to at least one of claims 1 to 19, in which a first hole area, through which an optical signal passes, is defined;
an electronic optical module (ELM) disposed under the display device (DD), overlapping the first hole area, and configured to receive the optical signal; and
a case (CAS) accommodating the display device (DD) and the electronic optical module (ELM).
